# EUROPEAN PATENT APPLICATION

(11) **EP 4 418 044 A1**
(43) Date of publication of application: **21.08.2024**
(21) Application number: 24156040.8
(22) Date of filing: 06.02.2024
(51) Int. Cl.: G03F 7/09, G03F 7/40

(54) **COMPOUND FOR FORMING METAL-CONTAINING FILM, COMPOSITION FOR FORMING METAL-CONTAINING FILM, AND PATTERNING PROCESS**

(30) Priority: 15.02.2023 JP 2023022005
(71) Applicant: SHIN-ETSU CHEMICAL CO., LTD., Tokyo 1000005 (JP)
(72) Inventor: IWAMORI, Shohei, Niigata (JP); KOBAYASHI, Naoki, Niigata (JP); KORI, Daisuke, Niigata (JP)
(74) Representative: Sonnenhauser, Thomas Martin

(57) **Abstract**

The present invention is a compound for forming a metal-containing film, represented by the following general formula (M), where T's each represent a unit represented by the following general formula (1); Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups; and R^{A} represents an organic group whose protecting group is to be removed by an action of an acid, heat, or both to generate one or more hydroxy groups or carboxyl groups. This provides a compound for forming a metal-containing film that can provide a composition for forming a metal-containing film having better dry etching resistance than conventional resist underlayer film materials and also having high filling and planarizing properties.

Tₙ-Sn-Qₘ (M)

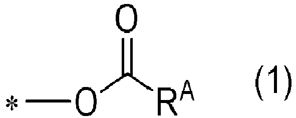

## Description

### TECHNICAL FIELD

The present invention relates to: a compound for forming a metal-containing film; a composition for forming a metal-containing film; and a patterning process using the composition.

### BACKGROUND ART

As LSIs advance toward higher integration and higher processing speed, miniaturization of pattern rule is progressing rapidly. As a cutting-edge technology for miniaturization, ArF immersion lithography has been adopted for mass-producing 45-nm node devices and smaller. In addition to ArF immersion exposure, double exposure (double patterning) processes have been put to practical use in generations of 28-nm node devices and smaller, so that the formation of narrow-pitch patterns that exceed the optical limit has also become possible.

Furthermore, in the production of 20-nm node and smaller devices, studies have been carried out on multiple exposure (multi-patterning) processes for forming a pattern with a narrower pitch by repeating exposure and etching three or more times. However, multiple exposure processes have an increased number of steps, and are faced with the situation that costs rise considerably due to degradation in productivity caused by longer time spent in manufacturing and more frequent generation of defects.

In recent years, vacuum ultraviolet ray (EUV) lithography with a wavelength of 13.5 nm is attracting attention as an effective technology to replace a combination of ArF immersion lithography and multiple exposure process. By using this technology, it has become possible to form a fine pattern with a half pitch of 25 nm or less in one exposure.

Meanwhile, in EUV lithography, resist materials are strongly required to have higher sensitivity to compensate for insufficient output of a light source. However, increase in shot noise accompanying higher sensitization leads to increase in edge roughness (LER and LWR) of line patterns, and obtaining both of higher sensitization and low edge roughness is given as an important problem in EUV lithography.

As an attempt to achieve higher sensitivity of a resist or to lower the influence of shot noise, it has been considered in recent years to use a metal material in a resist material. A compound that contains a metallic element such as barium, titanium, hafnium, zirconium, or tin has a higher absorbance of EUV light compared to an organic material that does not contain metal, and improvement of photosensitivity of resists and suppression of the influence of shot noise can be expected. Furthermore, a metal-containing resist pattern is expected to achieve a high-selectivity etching process by combining with an underlayer film made from a non-metal material.

For example, resist materials with added metal salt or organometallic complex disclosed in Patent Documents 1 and 2 or non-chemically amplified resist materials that use nanoparticles of metal oxide disclosed in Patent Documents 3 and 4 are considered.

In particular, molecules containing tin are excellent in the absorption of an electron beam and an extreme ultraviolet ray, and are actively researched. In the case of an organotin polymer, which is one such molecule, alkyl ligand is dissociated by light absorption or secondary electrons generated thereby and crosslinked with adjacent chains through an oxo bond, and thus enables the negative tone patterning which may not be removed by an organic developing solution. This organic tin polymer can improve sensitivity while maintaining a resolution and line edge roughness, but has not yet reached the standards for commercial availability (Patent Document 5). In addition, many problems still remain, such as insufficient storage stability regarding change in resist sensitivity.

To solve the problems, there is also consideration of development of the use of a material containing a metal element, such as titanium, hafnium, zirconium, and tin, for a resist underlayer film. There is no need for the improvement for performance, such as the enhancement of exposure sensitivity and the suppression of change in sensitivity in storage environment, which are issues in resist materials containing metal. In addition, it may be possible to provide a resist underlayer film excellent in dry etching resistance when the metal element is contained. Patent Document 6 reports that a material containing a Ti compound exhibits excellent dry etching resistance to CHF₃/CF₄-based gas and CO₂/N₂-based gas.

On the other hand, filling property is a problem when using a metal compound for a resist underlayer film. Although there is no mention of filling property in Patent Document 6, a metal oxide compound generally undergoes large thermal shrinkage during baking and induces remarkable degradation of filling property after baking at a high temperature. Therefore, there is a concern that such a compound is insufficient as a resist underlayer film material for which high planarizing and filling properties and heat resistance are required. Patent Document 7 reports that a metal compound modified with a particular ligand has excellent filling property. However, the baking temperature in the performed filling property evaluation is a low temperature of 150°C, and there is a concern that the compound is insufficient as a resist underlayer film, which requires heat resistance (for example, resistance to a heat treatment that is performed after the formation of a resist underlayer film in some cases). Patent Document 8 provides a resist underlayer film material excellent in filling property after baking at 400°C by mixing the metal compound reported in Patent Document 7 and an organic polymer having a particular structure. However, since the material is a mixed composition of a metal compound which is inorganic and a polymer which is organic, there are concerns for film formation defects, degradation of storage stability, degradation of dry etching resistance, etc. caused by compatibility failure.

### CITATION LIST

### PATENT LITERATURE

Patent Document 1: JP5708521B2
Patent Document 2: JP5708522B2
Patent Document 3: US9310684B2
Patent Document 4: US2017/0102612A1
Patent Document 5: JP2021-162865A
Patent Document 6: JP6189758B2
Patent Document 7: JP7050137B2
Patent Document 8: JP2022-521531A

### SUMMARY OF INVENTION

### TECHNICAL PROBLEM

The present invention has been made in view of the above-described circumstances. An object of the present invention is to provide: a compound for forming a metal-containing film that can provide a composition for forming a metal-containing film having better dry etching resistance than conventional resist underlayer film materials and also having high filling and planarizing properties; a composition for forming a metal-containing film containing the compound; and a patterning process in which the composition is used.

### SOLUTION TO PROBLEM

To achieve the object, the present invention provides a compound for forming a metal-containing film, wherein the compound is represented by the following general formula (M),

Tₙ-Sn-Qₘ (M)

wherein "m" and "n" represent integers that satisfy relationships m + n = 4, m ≥ 1, and n ≥ 2; T's each represent a unit represented by the following general formula (1), the T's being identical to or different from each other and optionally being a combination of a plurality of units; and Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups, 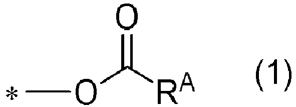 wherein R^{A} represents an organic group whose protecting group is to be removed by an action of an acid, heat, or both to generate one or more hydroxy groups or carboxyl groups, R^{A} being a group represented by one of the following general formulae (R^{A}-1) to (R^{A}-4); and "*" represents an attachment point to a Sn atom, 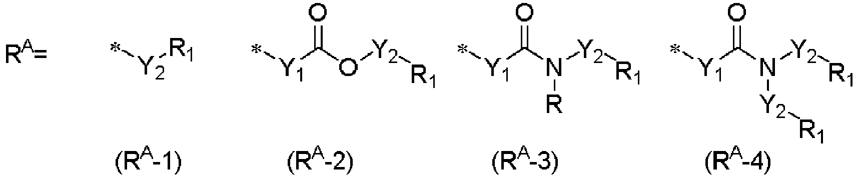 wherein Y₁ and Y₂ are identical to or different from each other and each represent a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms; R represents a hydrogen atom, a substituted or unsubstituted saturated monovalent organic group having 1 to 20 carbon atoms, a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms; R₁ represents an organic group represented by one of the following general formulae (2), wherein a protecting group of the organic group is to be removed by an action of an acid, heat, or both to generate one or more hydroxy groups or carboxyl groups; and "*" represents an attachment point to a carbonyl group, 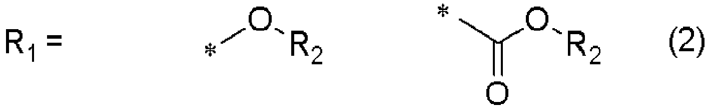 wherein R₂ represents an organic group whose protecting group is to be removed by an action of an acid, heat, or both and represents a tertiary hydrocarbyl group or a group that forms an acetal structure together with an adjacent oxygen atom; and "*" represents an attachment point to Y₂.

Such a tetravalent compound for forming a metal-containing film is a tin-containing compound having excellent solvent solubility. In addition, since a bulky heat/acid-labile group is included at the end R^{A}, thermal flowability can be enhanced. Furthermore, when the compound is contained in a composition for forming a metal-containing film, heat/acid-labile groups are removed during baking, and therefore, the Sn content increases, making it possible to form a metal-containing film having excellent etching resistance. Furthermore, hydroxy groups and carboxyl groups that are generated in this event react readily with radicals generated by the cleavage of tin-carbon bonds when baked, due to the presence of a terminal OH or an α-hydrogen, and therefore, a crosslinking reaction occurs. Thus, the composition is excellent in thermosetting property, and therefore, it is possible to suppress volume shrinkage, which induces degradation in filling property, and it is possible to provide a composition for forming a metal-containing film excellent in film-formability and planarizing and filling properties even after high-temperature baking.

The Y₁ in the general formulae (R^{A}-1) to (R^{A}-4) preferably represents an unsaturated hydrocarbon group having 2 to 20 carbon atoms.

When the Y₁ in the general formulae (R^{A}-1) to (R^{A}-4) represents an unsaturated hydrocarbon group having 2 to 20 carbon atoms, the thermosetting property of the compound for forming a metal-containing film can be improved further.

The Y₁ in the general formulae (R^{A}-1) to (R^{A}-4) preferably represents one of the following general formulae (3), 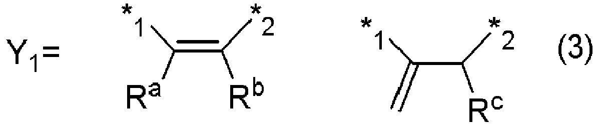 wherein R^{a}, R^{b}, and R^{c} each represent a hydrogen atom or a monovalent organic group having 1 to 20 carbon atoms, R^{a} and R^{b} optionally being bonded to each other to form a cyclic substituent; and "*1" and "*2" each represent an attachment point to a carbonyl group, "*1" and "*2" optionally being reversed.

A compound for forming a metal-containing film having such a structure can achieve high levels of both thermal flowability and thermosetting property. When this compound is contained in a composition for forming a metal-containing film, it is possible to provide a composition for forming a metal-containing film that exhibits better planarizing and filling properties.

The compound for forming a metal-containing film preferably satisfies 1.00 ≤ Mw/Mn ≤ 1.50, where Mw is a weight-average molecular weight and Mn is a number-average molecular weight measured by gel permeation chromatography in terms of polystyrene.

A compound for forming a metal-containing film having dispersity of such a range has even better thermal flowability, so that when the compound is contained in a composition for forming a metal-containing film, not only is it possible to fill favorably a fine structure formed on a substrate, it is also possible to form a metal-containing film so that the entire substrate is flat.

In addition, the present invention provides a composition for forming a metal-containing film, comprising:
(A) the inventive compound for forming a metal-containing film;
(B) an organic solvent; and
(C) an acid generator.

Such a composition for forming a metal-containing film contains an organotin compound excellent in solvent solubility and thermal flowability, and therefore, is a composition for forming a metal-containing film having better dry etching resistance than conventional resist underlayer film materials and also having high filling and planarizing properties.

The composition can further comprise one or more of:
(D) a compound or a polymer containing one or more of epoxy, oxetane, and hydroxy groups;
(E) a crosslinking agent;
(F) a surfactant; and
(G) a flowability accelerator.

When a compound or polymer (D) having an epoxy, oxetane, and/or hydroxy groups is contained, the groups react with hydroxy groups and carboxyl groups that are generated from the compound (A) for forming a metal-containing film during baking, and thus, thermal shrinkage can be suppressed. Furthermore, when hydroxy groups are contained, the groups undergo a crosslinking reaction with tin, and further suppression of thermal shrinkage can be expected.

Furthermore, a composition for forming a metal-containing film containing the additives (E) to (G) makes it possible to form a metal-containing film having better coating property, dry etching resistance, and filling and planarizing properties.

The organic solvent (B) preferably contains (B1) a high-boiling-point solvent, the high-boiling-point solvent (B1) being one or more kinds of organic solvent having a boiling point of 180°C or higher.

By the organic solvent (B) containing a high-boiling-point solvent (B1), which is an organic solvent having a boiling point of 180°C or higher, the composition for forming a metal-containing film is provided with further thermal flowability. Thus, such a composition for forming a metal-containing film has higher filling and planarizing properties.

In addition, the present invention provides a patterning process for forming a pattern in a substrate to be processed, comprising the steps of:
(I-1) applying the inventive composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

The patterning process according to the two-layer resist process makes it possible to form fine patterns on the body to be processed (substrate to be processed).

The present invention also provides a patterning process for forming a pattern in a substrate to be processed, comprising the steps of:
(II-1) applying the inventive composition for forming a metal-containing film onto a substrate to be processed, followed by heating to form a metal-containing film;
(II-2) forming a silicon-containing resist middle layer film on the metal-containing film;
(II-3) forming a resist upper layer film on the silicon-containing resist middle layer film by using a photoresist material;
(II-4) subjecting the resist upper layer film to pattern exposure and then development with a developer to form a pattern in the resist upper layer film;
(II-5) transferring the pattern to the silicon-containing resist middle layer film by dry etching while using the resist upper layer film having the formed pattern as a mask;
(II-6) transferring the pattern to the metal-containing film by dry etching while using the silicon-containing resist middle layer film having the transferred pattern as a mask; and
(II-7) processing the substrate to be processed while using the metal-containing film having the formed pattern as a mask to form the pattern in the substrate to be processed.

The patterning process according to the three-layer resist process makes it possible to form fine patterns on the body to be processed with a high degree of accuracy.

The present invention also provides a patterning process for forming a pattern in a substrate to be processed, comprising the steps of:
(III-1) applying the inventive composition for forming a metal-containing film onto a substrate to be processed, followed by heating to form a metal-containing film;
(III-2) forming an inorganic hard mask middle layer film selected from the group consisting of a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

The patterning process according to the four-layer resist process makes it possible to form fine patterns on the body to be processed with a high degree of accuracy.

In this case, the inorganic hard mask middle layer film is preferably formed by a CVD method or an ALD method.

When the inorganic hard mask middle layer film is formed by a CVD method or an ALD method, a fine pattern can be formed on a body to be processed with higher accuracy.

The present invention also provides a patterning process for forming a pattern in a substrate to be processed, comprising the steps of:
(IV-1) forming a resist underlayer film on a substrate to be processed;
(IV-2) applying the inventive composition for forming a metal-containing film onto the resist underlayer film, followed by heating to form a metal-containing film;
(IV-3) forming a resist upper layer film on the metal-containing film by using a photoresist material or forming an organic adhesive film on the metal-containing film by spin-coating and forming a resist upper layer film on the organic adhesive film by using a photoresist material;
(IV-4) subjecting the resist upper layer film to pattern exposure and then development with a developer to form a pattern in the resist upper layer film;
(IV-5) transferring the pattern to the organic adhesive film and the metal-containing film or the metal-containing film by dry etching while using the resist upper layer film having the formed pattern as a mask;
(IV-6) transferring the pattern to the resist underlayer film by dry etching while using the metal-containing film having the transferred pattern as a mask; and
(IV-7) processing the substrate to be processed while using the resist underlayer film having the formed pattern as a mask to form the pattern in the substrate to be processed.

The patterning process according to the multilayer resist process makes it possible to form fine patterns on the body to be processed with a high degree of accuracy.

The present invention also provides a tone-reversal patterning process for forming a pattern in a substrate to be processed, comprising the steps of:
(V-1) forming a resist underlayer film on a substrate to be processed;
(V-2) forming a resist middle layer film or a combination of an organic thin film and an inorganic hard mask middle layer film selected from the group consisting of a silicon oxide film, a silicon nitride film, and a silicon oxynitride film on the resist underlayer film;
(V-3) forming a resist upper layer film on the resist middle layer film or the combination of the organic thin film and the inorganic hard mask middle layer film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film having the transferred pattern or the inorganic hard mask middle layer film having the transferred pattern as a mask;
(V-7) applying the inventive composition for forming a metal-containing film onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing the resist underlayer film having the formed pattern with its surface exposed by dry etching to form a reverse pattern of an original pattern on the metal-containing film; and
(V-11) processing the substrate to be processed while using the metal-containing film having the formed reverse pattern as a mask to form the reverse pattern in the substrate to be processed.

The patterning process according to the reverse process makes it possible to form fine patterns on the body to be processed with an even higher degree of accuracy.

### ADVANTAGEOUS EFFECTS OF INVENTION

As described above, the inventive compound for forming a metal-containing film has a structure represented by the general formula (M), and therefore, is excellent in solvent solubility and thermal flowability. Furthermore, since the compound contains a heat/acid-labile group in a terminal structure R^{A} in the general formula (1), when the compound is contained in a composition for forming a metal-containing film, the heat/acid-labile group is removed during baking, so that Sn content increases, and it is possible to form a metal-containing film having excellent etching resistance. Furthermore, hydroxy groups and carboxyl groups generated on this occasion react readily with radicals generated by the cleavage of tin-carbon bonds when baked, due to the presence of a terminal OH or an α-hydrogen, and therefore, a crosslinking reaction occurs. Thus, the composition is excellent in thermosetting property, and therefore, it is possible to suppress volume shrinkage, which induces degradation in filling property, and the composition for forming a metal-containing film can exhibit excellent film-formability and planarizing and filling properties even after baking at a high temperature.

In particular, in a fine patterning process using a multilayer resist method in a semiconductor device manufacturing process, filling is possible without causing defects such as voids and peeling even on a substrate to be processed having a portion that is difficult to fill and planarize, such as a dense portion of a fine pattern structure having a high aspect ratio exemplified by increasingly miniaturized DRAM. In addition, the inventive compound has better dry etching resistance than conventional coating-type organic resist underlayer film materials, and therefore, a fine pattern can be formed on a body to be processed with even higher precision compared with an organic resist underlayer film.

The inventive composition for forming a metal-containing film containing the inventive compound for forming a metal-containing film contains tin atoms, which have high light absorbance, and therefore, has a sensitizing effect caused by secondary electrons generated from the tin atoms during exposure. Furthermore, tin atoms have a great atomic weight, and therefore, have a high effect of suppressing the diffusion of acid from an upper layer resist to a resist underlayer film, and have a characteristic that higher sensitivity can be achieved while sustaining the LWR performance that the resist upper layer film originally has.

According to the inventive patterning process, using the inventive composition for forming a metal-containing film, a fine pattern can be formed on a body to be processed with high precision.

### BRIEF DESCRIPTION OF DRAWINGS

FIG. 1 is an explanatory view of an example (three-layer resist process) of the patterning process of the present invention.
FIG. 2 is an explanatory view of an example (forming reverse SOC pattern of a three-layer resist process) of the tone-reversal patterning process of the present invention.
FIG. 3 is an explanatory view of a method for evaluating the filling property.
FIG. 4 is an explanatory view of a method for evaluating the planarizing property.

### DESCRIPTION OF EMBODIMENTS

As stated above, there have been demands for the development of: a composition for forming a metal-containing film, excellent in filling property and planarization property, used for forming a resist film that makes it possible to transfer a resist pattern to a substrate to be processed with higher precision in a fine patterning process according to a multilayer resist method; and a compound for forming a metal-containing film useful for the composition.

The present inventors have focused on organotin compounds, which are expected to play an active role in the EUV-exposure generation, and studied earnestly. As stated above, tin atoms, which greatly absorb light, have a sensitizing effect due to secondary electrons generated from the atoms during exposure, and have a characteristic that higher sensitivity can be achieved while maintaining the LWR performance that a resist upper layer film originally has. On the other hand, organotin compounds, which are considered as resist upper layer films, have poor heat resistance, and undergo rapid volume shrinkage during baking. Therefore, it is difficult to fill and planarize the steps of a substrate to be processed after high-temperature baking. The present inventors have considered that a compound having an organic group excellent in heat resistance and, on a terminal, a heat/acid-labile group can improve solvent solubility and thermal flowability. The present inventors have also considered that when this compound is contained in a composition for forming a metal-containing film, Sn content increases because heat/acid-labile groups are removed at the time of baking, so that a composition for forming a film excellent in etching resistance can be achieved. The present inventors have also considered that hydroxy groups and carboxyl groups that are generated when the heat/acid-labile groups are removed react easily with radicals generated by the cleavage of tin-carbon bonds when baked, due to the presence of a terminal OH or an α-hydrogen, and that therefore, a crosslinking reaction occurs, so that the composition is excellent in thermosetting property. Thus, it is possible to suppress volume shrinkage, which induces degradation in filling property, and therefore, it is possible to fill steps of a substrate to be processed even after high-temperature baking.

The present inventors have studied earnestly further, and found out that a compound for forming a metal-containing film represented by the general formula (M) can, by containing a tin atom, contribute to the improvement of sensitivity while maintaining the LWR of an upper layer resist, and has excellent solvent solubility and thermal flowability. In addition, it has been found that after the removal of heat/acid-labile groups, generated hydroxy groups and carboxylic acid function as crosslinking groups and can suppress rapid volume shrinkage during baking, and therefore, excellent filling and planarizing properties can be realized. Furthermore, it has been found that tin content is increased by the removal of the heat/acid-labile groups, and the compound for forming a metal-containing film also has excellent etching resistance. Thus, the present invention has been completed.

That is, the present invention is a compound for forming a metal-containing film, wherein the compound is represented by the following general formula (M),

Tₙ-Sn-Qₘ (M)

wherein "m" and "n" represent integers that satisfy relationships m + n = 4, m ≥ 1, and n ≥ 2; T's each represent a unit represented by the following general formula (1), the T's being identical to or different from each other and optionally being a combination of a plurality of units; and Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups, 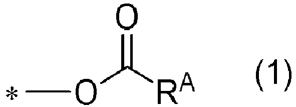 wherein R^{A} represents an organic group whose protecting group is to be removed by an action of an acid, heat, or both to generate one or more hydroxy groups or carboxyl groups, R^{A} being a group represented by one of the following general formulae (R^{A}-1) to (R^{A}-4); and "*" represents an attachment point to a Sn atom, 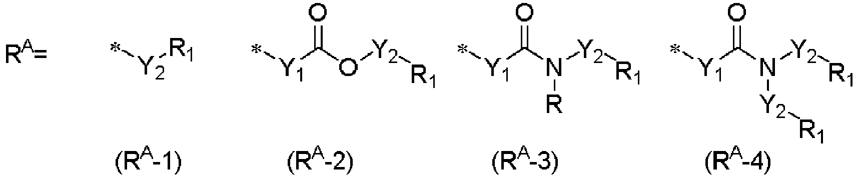 wherein Y₁ and Y₂ are identical to or different from each other and each represent a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms; R represents a hydrogen atom, a substituted or unsubstituted saturated monovalent organic group having 1 to 20 carbon atoms, a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms; R₁ represents an organic group represented by one of the following general formulae (2), wherein a protecting group of the organic group is to be removed by an action of an acid, heat, or both to generate one or more hydroxy groups or carboxyl groups; and "*" represents an attachment point to a carbonyl group, 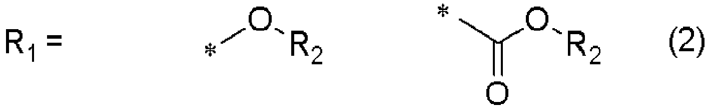 wherein R₂ represents an organic group whose protecting group is to be removed by an action of an acid, heat, or both and represents a tertiary hydrocarbyl group or a group that forms an acetal structure together with an adjacent oxygen atom; and "*" represents an attachment point to Y₂.

Hereinafter, the present invention will be described in detail, but the present invention is not limited thereto.

### <Compound for Forming Metal-Containing Film>

The inventive compound for forming a metal-containing film is represented by the following general formula (M),

Tₙ-Sn-Qₘ (M)

In the general formula (M), "m" and "n" represent integers that satisfy relationships m + n = 4, m ≥ 1, and n ≥ 2. T's each represent a unit represented by the following general formula (1), the T's being identical to or different from each other and optionally being a combination of a plurality of units. Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups.

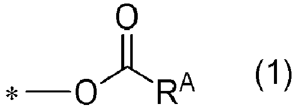

In the general formula (1), R^{A} represents an organic group whose protecting group is to be removed by an action of an acid, heat, or both to generate one or more hydroxy groups or carboxyl groups, R^{A} being a group represented by one of the following general formulae (R^{A}-1) to (R^{A}-4); and "*" represents an attachment point to a Sn atom.

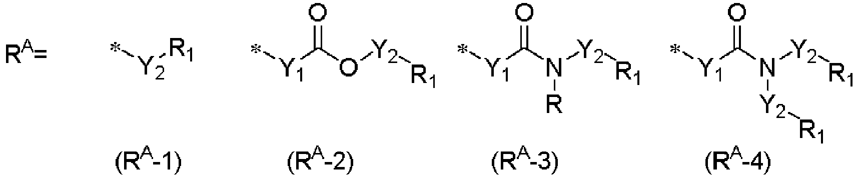

In the general formulae (R^{A}-1) to (R^{A}-4), Y₁ and Y₂ are identical to or different from each other and each represent a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms. R represents a hydrogen atom, a substituted or unsubstituted saturated monovalent organic group having 1 to 20 carbon atoms, a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms; R₁ represents an organic group represented by one of the following general formulae (2), and a protecting group of the organic group is to be removed by an action of an acid, heat, or both to generate one or more hydroxy groups or carboxyl groups; and "*" represents an attachment point to a carbonyl group.

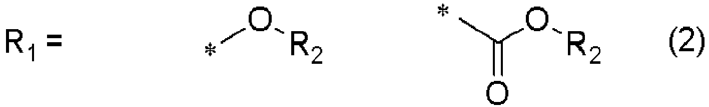

In the general formulae (2), R₂ represents an organic group whose protecting group is to be removed by an action of an acid, heat, or both and represents a tertiary hydrocarbyl group or a group that forms an acetal structure together with an adjacent oxygen atom. "*" represents an attachment point to Y₂.

The compound represented by the general formula (M) can be synthesized by condensation of tin oxide, tin chloride, or the like with a carboxylic acid including R^{A}, as in the following formula. Therefore, T may be of one kind or may be a combination of multiple kinds, and from the viewpoint of solvent solubility, a combination of multiple kinds is preferable.

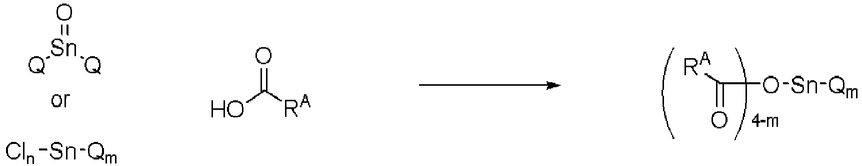

Furthermore, as shown in the following formula, it is also possible to use a carboxylic acid different from the carboxylic acid including R^{A} in combination. For example, in accordance with required performance, such as film-formability and solvent solubility, a carboxylic acid component having a terminal group or functional group different from the terminal group of the present invention may be contained and combined at any proportion. In the following formula, R' represents any substituent, "n" and "m" are as described in the description of the general formula (M), and "m₁" and "m₂" represent integers that satisfy m₁ + m₂ + m = 4.

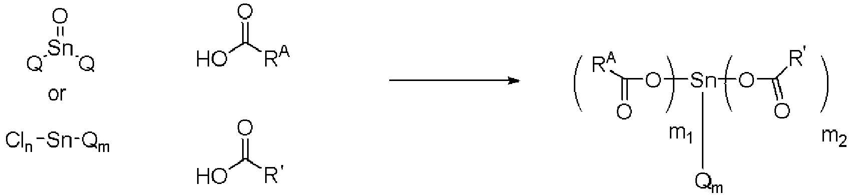

As specific examples of a carboxylic acid to be mixed, a carboxylic acid shown below can be used. It is possible to select appropriately a carboxylic acid to be added depending on the purpose, for example, when it is desired to provide further thermosetting property, a carboxylic acid including an unsaturated bond, etc. can be selected, and when it is desired to improve thermal flowability, a carboxylic acid containing a long chain alkyl or the like can be selected, etc. In addition, since crystallinity can be suppressed by mixing the carboxylic acids, solvent solubility and thermal flowability are also improved. Meanwhile, from the viewpoint of achieving sufficient improvement of thermal flowability with heat/acid-labile groups and sufficient thermal crosslinking with carboxy groups and hydroxy groups after removal of the heat/acid-labile groups, the carboxylic acid including R^{A} is preferably charged at a proportion of 50 mol% or more, further preferably 70 mol% or more of all the carboxylic acids.

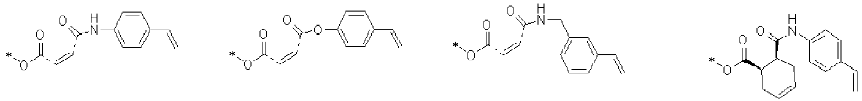

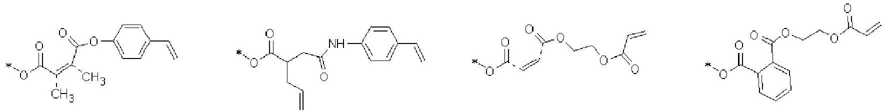

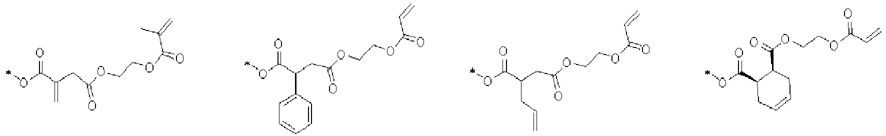

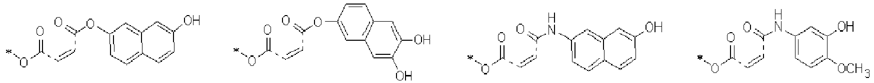

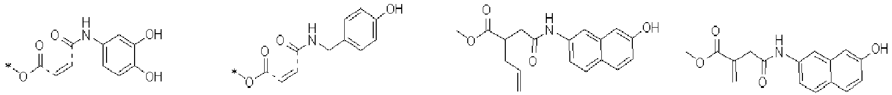

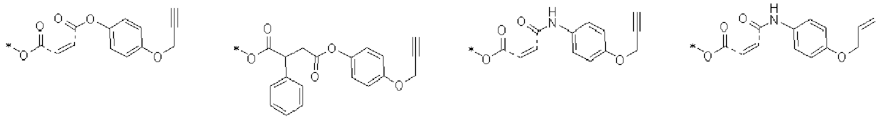

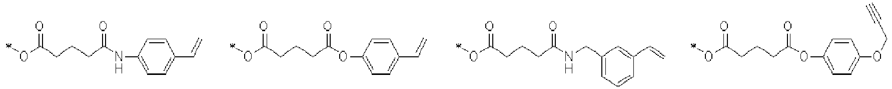

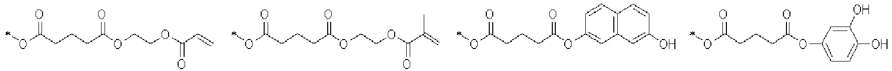

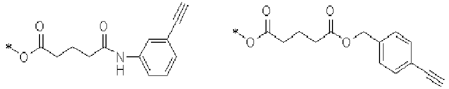

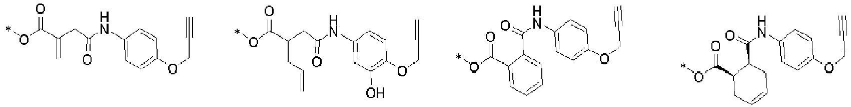

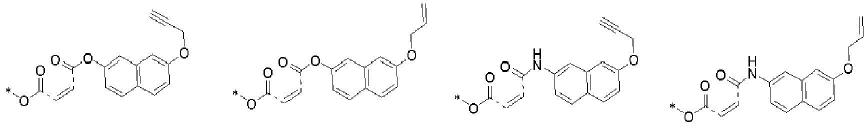

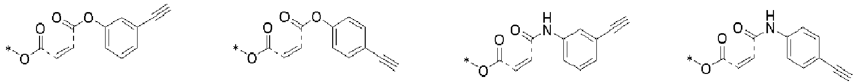

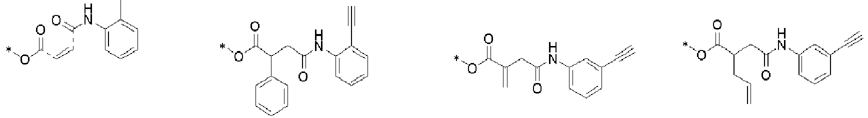

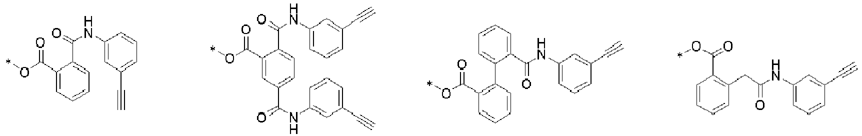

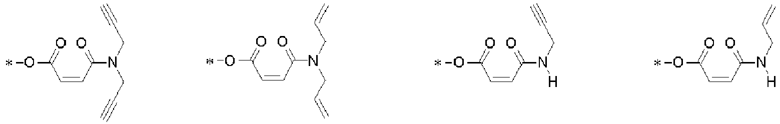

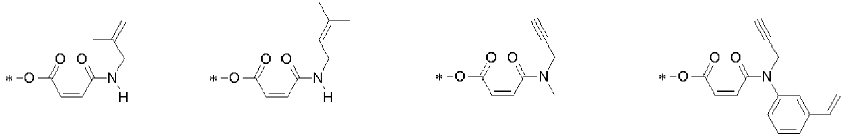

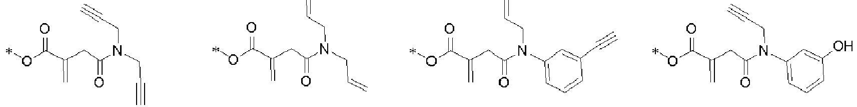

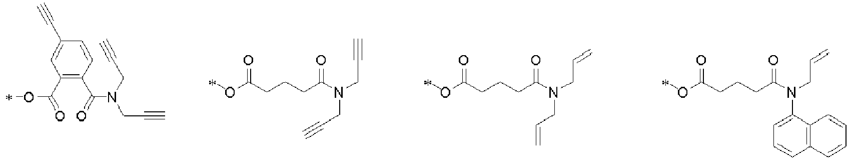

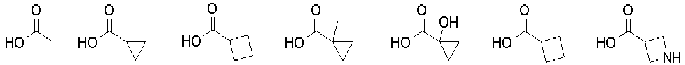

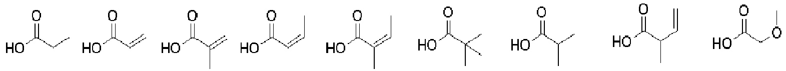

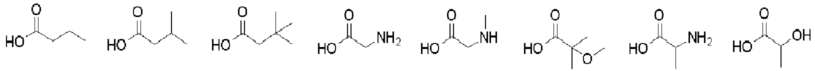

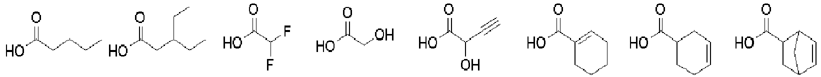

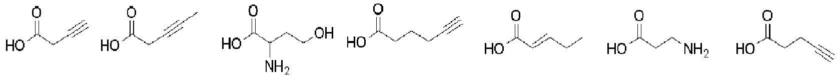

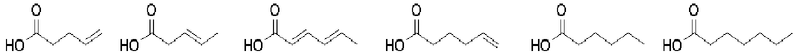

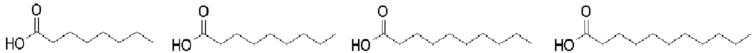

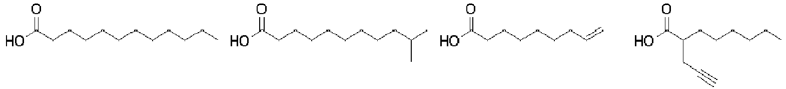

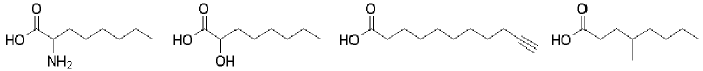

In the general formula (M), Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups. An unsubstituted alkyl group having 1 to 20 carbon atoms is more preferable, and from the availability of raw materials, an n-butyl group is particularly preferable.

In the general formula (M), "m" and "n" represent integers that satisfy relationships m + n = 4, m ≥ 1, and n ≥ 2. "n" and "m" are preferably n = 3 and m = 1 or n = 2 and m = 2 from the viewpoints of the safety and thermal flowability of the compound, and are particularly preferably n = 2 and m = 2 from the availability of raw materials.

In the general formula (1), R^{A} represents a group represented by one of the general formulae (R^{A}-1) to (R^{A}-4), and (R^{A}-2), (R^{A}-3), and (R^{A}-4), which are structures that can be obtained by ring-opening an acid anhydride, can adjust the compound to have a desired molecular weight, and are preferable.

In the general formulae (R^{A}-1) to (R^{A}-4), Y₁ and Y₂ are identical to or different from each other and each represent a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms. R represents a hydrogen atom, a substituted or unsubstituted saturated monovalent organic group having 1 to 20 carbon atoms, a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms; R₁ represents an organic group represented by one of the general formulae (2), and a protecting group of the organic group is to be removed by an action of an acid, heat, or both to generate one or more hydroxy groups or carboxyl groups; and "*" represents an attachment point to a carbonyl group.

In the general formulae (2), R₂ represents an organic group whose protecting group is to be removed by an action of an acid, heat, or both and represents a tertiary hydrocarbyl group or a group that forms an acetal structure together with an adjacent oxygen atom. "*" represents an attachment point to Y₂.

In the general formula (R^{A}-3), R is preferably a hydrogen atom in view of the availability of starting materials.

Examples of preferable structures of the Y₂ in the general formulae (R^{A}-1) to (R^{A}-4) include the following structures, but are not limited thereto. In the following formulae, "*ₐ" represents an attachment point to R₁, and "*_{b}" represents the other attachment point.

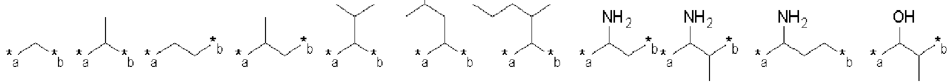

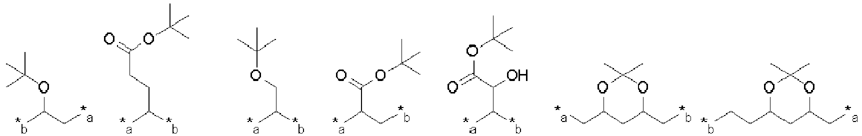

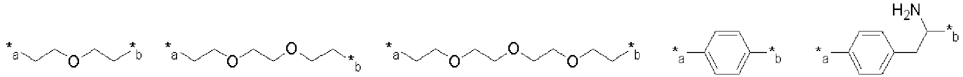

In the general formulae (2), R₂ represents an organic group whose heat/acid-labile group is to be removed by an action of an acid, heat, or both (hereinafter, also referred to as a heat/acid-labile group) and represents a tertiary hydrocarbyl group or a group that forms an acetal structure together with an adjacent oxygen atom. A tertiary hydrocarbyl group is particularly preferable.

As the tertiary hydrocarbyl group, a tertiary hydrocarbyl group having 4 to 20 carbon atoms is preferable, and from the viewpoints of suppressing sublimation products caused by thermal decomposition products and ease of obtaining starting materials, a tert-butyl group is particularly preferable. Specific examples include those shown below, but are not limited thereto. Note that in the following formulae, "*" represents an attachment point to an oxygen atom.

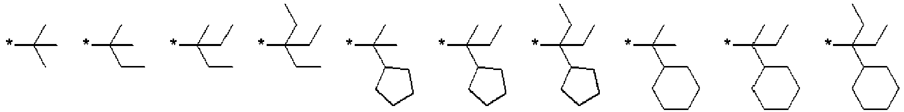

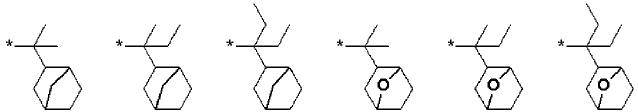

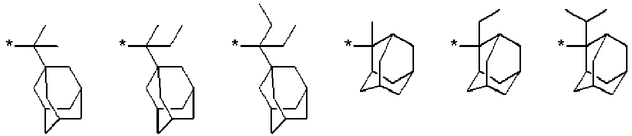

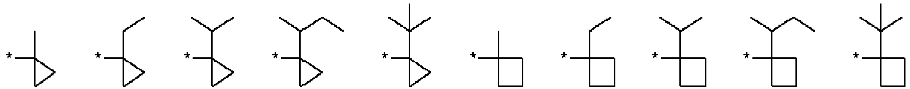

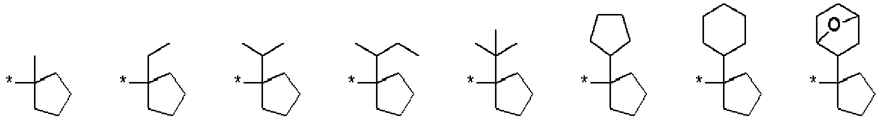

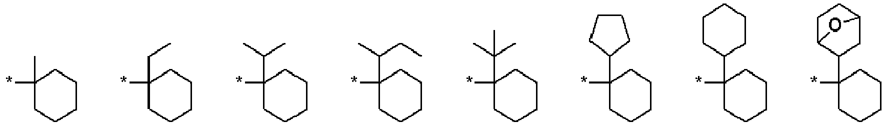

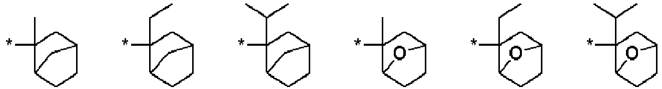

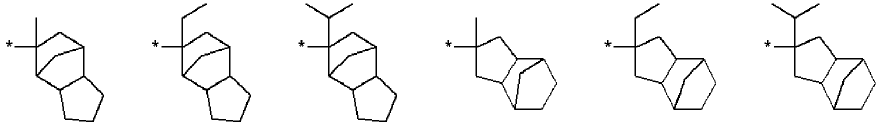

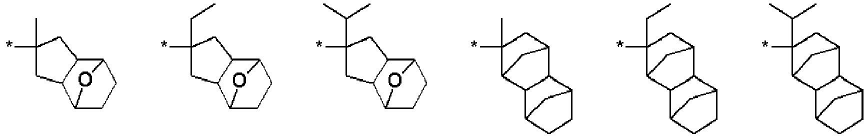

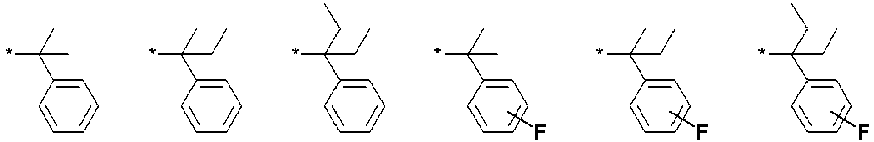

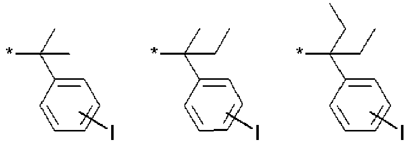

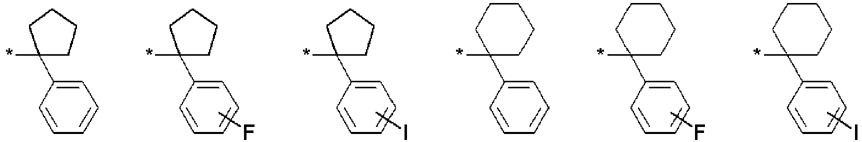

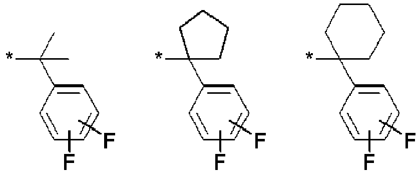

Specific examples of the group that forms an acetal structure include the following, but are not limited thereto. Note that in the following formulae, "*" represents an attachment point to an oxygen atom.

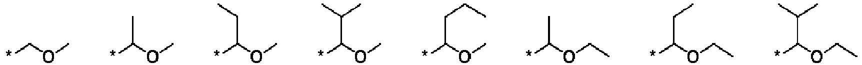

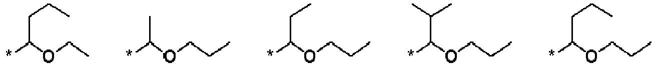

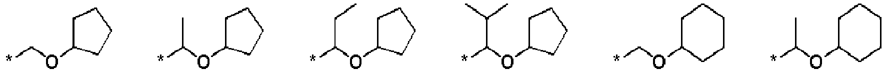

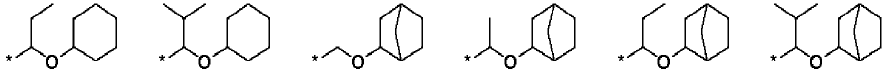

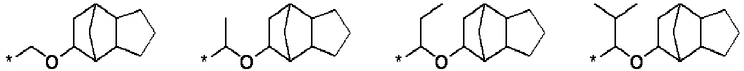

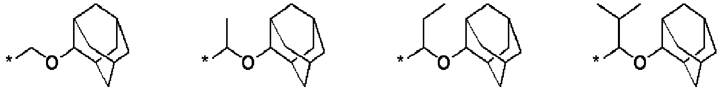

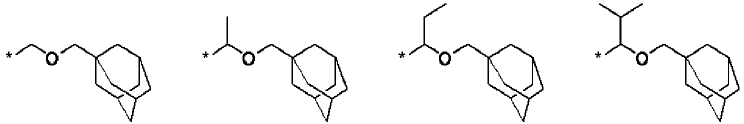

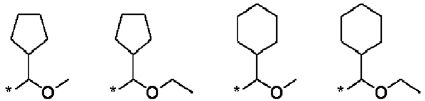

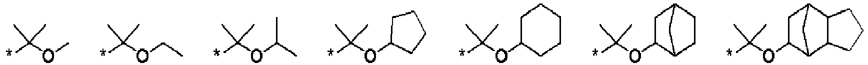

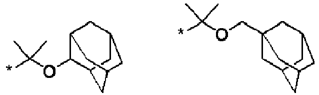

Such a compound for forming a metal-containing film is excellent in solvent solubility and thermal flowability. Furthermore, since such a compound contains a heat/acid-labile group in the R^{A}, when the compound is contained in a composition for forming a metal-containing film, the tin content increases because the heat/acid-labile groups are removed during baking. Thus, a metal-containing film excellent in dry etching resistance can be formed. Moreover, hydroxy groups and carboxyl groups generated by the removal react readily with radicals generated by the cleavage of tin-carbon bonds when baked, due to the presence of a terminal OH or an α-hydrogen, and therefore, a crosslinking reaction occurs. Thus, the composition has excellent thermosetting property, and therefore, it is possible to suppress volume shrinkage, and it is possible to provide a composition for forming a metal-containing film excellent in film-formability and planarizing and filling properties even after baking at a high temperature. For example, the inventive compound for forming a metal-containing film can be contained in a composition for forming a metal-containing film that functions as resist underlayer film material used in semiconductor production.

A metal-containing film formed by using an organotin compound generates radicals, while organic groups bonded to Sn atoms via C atoms are dissociated during baking. The generated radicals form -Sn-O-Sn- bonds and initiate a condensation polymerization reaction. Thus, curing of the metal-containing film progresses. Meanwhile, since organic groups are removed at the time of the reaction, great film shrinkage occurs during baking. However, the above-described compound has a heat/acid-labile group at an end, and the heat/acid-labile group is removed during baking to generate a hydroxy group or a carboxyl group. The terminal OH and α-hydrogen in these groups react easily with radicals, and a crosslinking reaction occurs in the manner of the following reaction formula. Since the compound has at least one of such an organic group, it is possible to suppress the thermal decomposition of all the organic groups and sublimation, and the composition has excellent thermal flowability. Therefore, it is possible to provide a composition for forming a metal-containing film excellent in filling property.

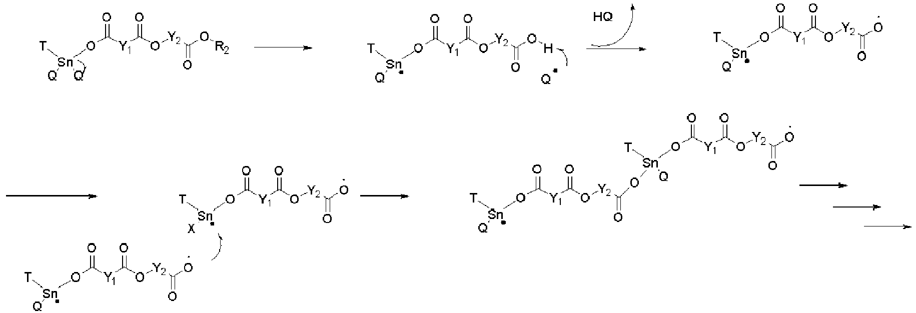

In the general formulae (R^{A}-1) to (R^{A}-4), Y₁ preferably represents an unsaturated hydrocarbon group having 2 to 20 carbon atoms.

When the Y₁ is an unsaturated hydrocarbon group having 2 to 20 carbon atoms in the general formulae (R^{A}-1) to (R^{A}-4), the thermosetting property of the compound for forming a metal-containing film can be enhanced further.

Specific examples of the Y₁ in the general formulae (R^{A}-1) to (R^{A}-4) include the following structures, but are not limited thereto.

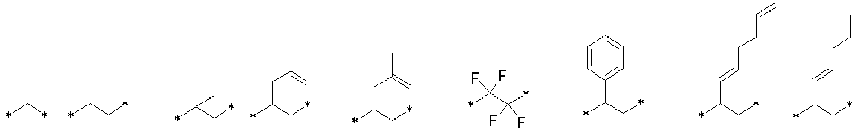

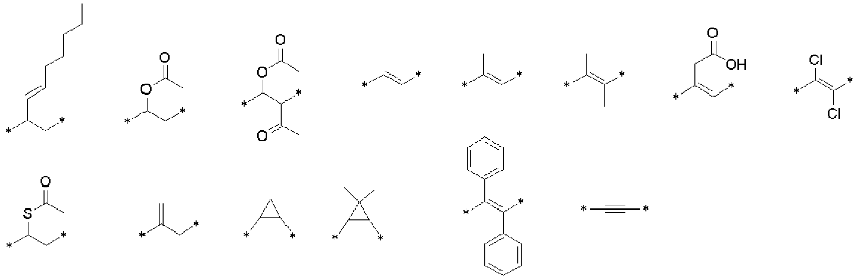

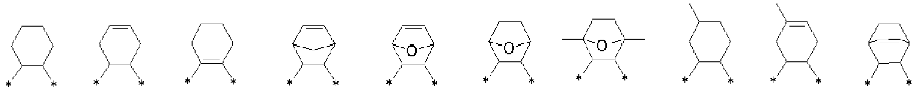

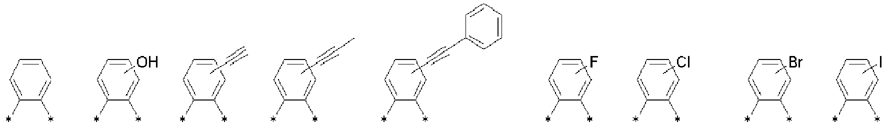

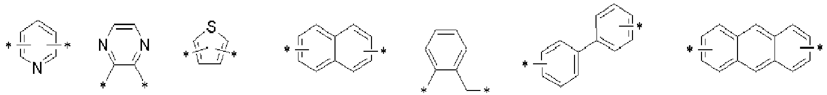

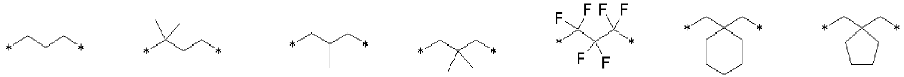

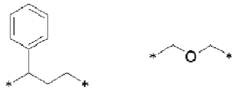

It is also possible to provide a compound for forming a metal-containing film, where the Y₁ in the general formulae (R^{A}-1) to (R^{A}-4) represents one of the following general formulae (3).

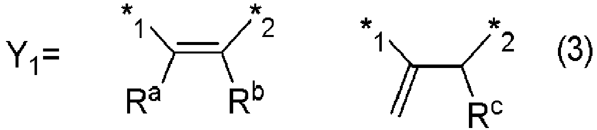

In the general formulae (3), R^{a}, R^{b}, and R^{c} each represent a hydrogen atom or a monovalent organic group having 1 to 20 carbon atoms, R^{a} and R^{b} optionally being bonded to each other to form a cyclic substituent. "*1" and "*2" each represent an attachment point to a carbonyl group, "*1" and "*2" optionally being reversed.

The synthesis of a compound that includes one of the general formulae (3) is performed by condensation between a tin oxide or a tin chloride, etc. and a carboxylic acid as in the following reaction formulae, and the carboxylic acid to be used can be synthesized by ring-opening an acid anhydride with an alcohol or an amine containing Y₂ and R₁. In the following formulae, "n" and "m" are as described in the description of the general formula (M), and "n₁" and "n₂" represent integers that satisfy n₁ + n₂ + m = 4. In this event, when an asymmetric carboxylic anhydride is ring-opened, a mixture of two kinds is obtained, and therefore, the above-described bonding form is obtained. Crystallinity can be suppressed by the presence of such isomers, and improvement in solvent solubility and improvement in thermal flowability can be expected.

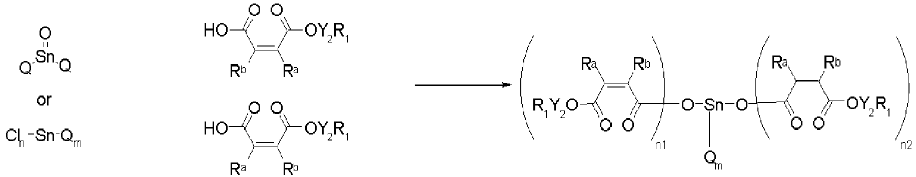

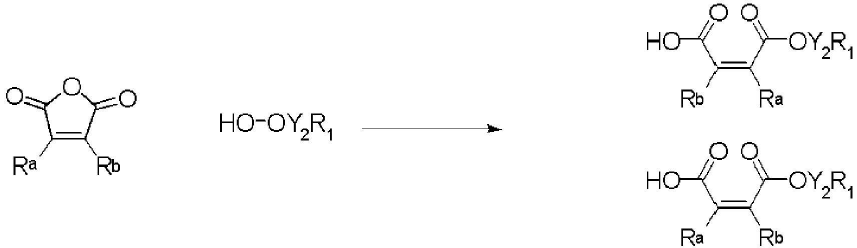

In the general formulae (3), R^{a}, R^{b}, and R^{c} each represent a hydrogen atom or a monovalent organic group having 1 to 20 carbon atoms, R^{a} and R^{b} optionally being bonded to each other to form a cyclic substituent. From the viewpoint of suppressing sublimation products, a hydrogen atom is particularly preferable.

A compound for forming a metal-containing film having such a structure can achieve both thermal flowability and thermosetting property, and when the compound is contained in a composition for forming a metal-containing film, it is possible to provide a resist material that maintains planarizing and filling properties.

The compound for forming a metal-containing film preferably has a ratio Mw/Mn of 1.00 ≤ Mw/Mn ≤ 1.50, where Mw is a weight-average molecular weight and Mn is a number-average molecular weight measured by gel permeation chromatography in terms of polystyrene.

From the definition, Mw/Mn is 1.00 in the case of a monomolecular compound, but because of separation in gel permeation chromatography, the measured value exceeds 1.00 in some cases. Generally, it is extremely difficult to bring the Mw/Mn of a polymer having a repeating unit close to 1.00 unless a special polymerization method is used. Such a polymer has a distribution of Mw, and Mw/Mn exceeds 1. In the present invention, the range 1.00 ≤ Mw/Mn ≤ 1.50 is defined as an index to indicate monomerism in order to distinguish between monomolecular compounds and polymers.

The compound for forming a metal-containing film having dispersity within such a range has even better thermal flowability, so that when the compound is contained in a composition for forming a metal-containing film, not only is it possible to fill favorably fine structures formed on a substrate, it is also possible to form a metal-containing film to planarize the entire substrate.

### <Composition for Forming Metal-Containing Film>

Furthermore, the present invention can provide a composition for forming a metal-containing film, containing:
(A) the inventive compound for forming a metal-containing film;
(B) an organic solvent; and
(C) an acid generator.

Such a composition for forming a metal-containing film contains an organotin compound excellent in heat resistance and thermal flowability, and therefore, can provide a metal-containing film material that has better dry etching resistance than conventional organic underlayer film materials and also has high filling and planarizing properties.

This composition for forming a metal-containing film can function as, for example, a resist material (e.g., a resist underlayer film material used in a multilayer resist method) used in manufacturing a semiconductor.

In the following, the components contained in the inventive composition for forming a metal-containing film other than the above-described inventive compound (A) for forming a metal-containing film will be described.

### <(B) Organic Solvent>

The organic solvent (B) usable in the inventive composition for forming a metal-containing film is not particularly limited as long as the solvent can dissolve the compound (A) for forming a metal-containing film and the acid generator (C), and when contained, optional components described below such as (D) a compound or a polymer having epoxy, oxetane, and/or hydroxy groups, (E) a crosslinking agent, (F) a surfactant, (G) a flowability accelerator, and other additives.

Specifically, an organic solvent disclosed in paragraphs [0091] and [0092] in JP2007-199653A may be contained. Further specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

The organic solvent is preferably contained in an amount of 200 to 10,000 parts, more preferably 250 to 5,000 parts relative to 100 parts by mass of the compound (A) for forming a metal-containing film.

The organic solvent (B) preferably contains (B1) a high-boiling-point solvent, the high-boiling-point solvent (B1) being one or more kinds of organic solvent having a boiling point of 180°C or higher.

When thermal flowability is imparted to the compound for forming a metal-containing film by a high-boiling-point solvent being contained, the composition for forming a metal-containing film has both high filling property and high planarizing property.

In the inventive composition for forming a metal-containing film, the organic solvent (B) may be, for example, a mixture of one or more kinds of organic solvent having a boiling point of lower than 180°C and one or more kinds of organic solvent having a boiling point of 180°C or higher ((B1) the high-boiling-point solvent).

The high-boiling-point solvent (B1) is not particularly limited to hydrocarbons, alcohols, ketones, esters, ethers, or chlorine-based solvents as long as the solvent is capable of dissolving the components of the inventive composition for forming a metal-containing film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The high-boiling-point solvent (B1) may be selected suitably from the solvents above, for example, depending on the temperature at which the inventive composition for forming a metal-containing film is heat-treated, etc. The boiling point of the high-boiling-point solvent is preferably 180°C to 300°C, further preferably 200°C to 300°C. It is considered that when the boiling point is as described, sufficient thermal flowability can be achieved at the time of film formation, since there is no risk of excessive evaporation rate at the baking (heating). Thus, it is possible to form a metal-containing film excellent in filling and planarizing properties. Moreover, a solvent having such a boiling point does not remain in the film without evaporating even after the baking. Therefore, there is no risk of the solvent adversely affecting the physical properties, such as etching resistance, of the film.

Furthermore, when the high-boiling-point solvent (B1) is used, the contained amount is preferably 1 to 30 parts by mass per 100 parts by mass of the organic solvent, having a boiling point lower than 180°C. When the contained amount is as described, sufficient thermal flowability can be imparted at the time of baking, so that the solvent does not remain in the film and cause degradation in the physical properties, such as etching resistance, of the film. Therefore, such an amount is preferable.

### <(C) Acid Generator>

An acid generator (C) is contained in the inventive composition for forming a metal-containing film in order to promote further the removal reaction of the compound (A) for forming a metal-containing film. The acid generator (C) can be classified into those that generate an acid by thermal decomposition and those that generate an acid by optical irradiation; however, any acid generator can be added. Specific examples of the acid generator include the materials disclosed in paragraphs [0061] to [0085] of JP2007-199653A, but are not limited thereto.

One kind of the acid generator (C) can be used, or two or more kinds can be used in combination. When an acid generator (C) is contained, the contained amount is preferably 0.05 to 50 parts, more preferably 0.1 to 10 parts relative to 100 parts by mass of the compound (A) for forming a metal-containing film.

### <Optional Components>

The inventive composition for forming a metal-containing film can further contain, as one or more optional components, one or more of:
(D) a compound or a polymer containing one or more of epoxy, oxetane, and hydroxy groups;
(E) a crosslinking agent;
(F) a surfactant; and
(G) a flowability accelerator.

In the following, the optional components that may be contained in the inventive composition for forming a metal-containing film besides the compound (A) for forming a metal-containing film, the organic solvent (B), and the acid generator (C) will be described.

### [(D) Compound or Polymer Containing One or More of Epoxy, Oxetane, and Hydroxy Groups]

The inventive composition for forming a metal-containing film can also contain a compound or a polymer (D) having epoxy, oxetane, and/or hydroxy groups in order to enhance curability. Moreover, hydroxy groups can be expected to enhance adhesiveness as well as curability.

Specific examples of compounds that contain an epoxy group include the following, but are not limited thereto.

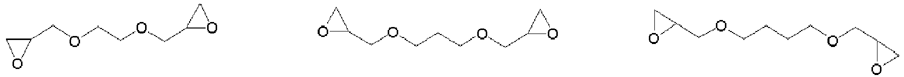

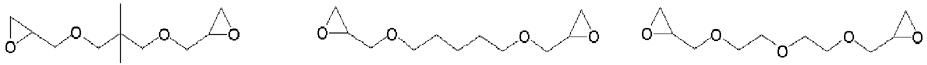

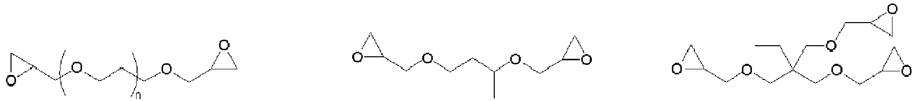

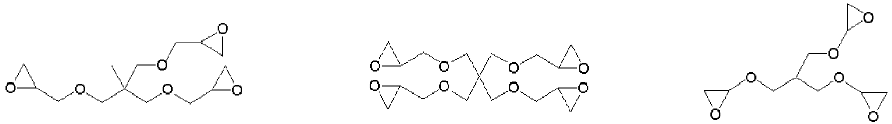

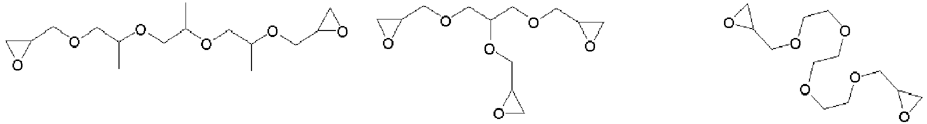

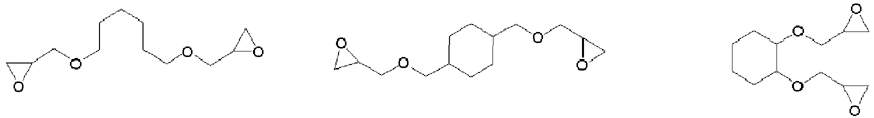

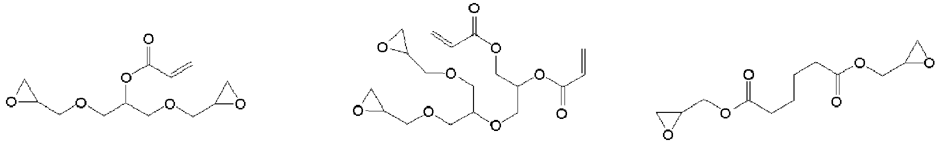

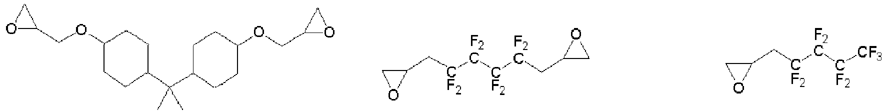

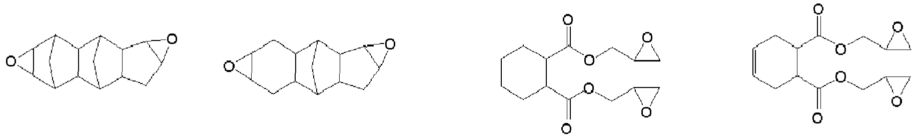

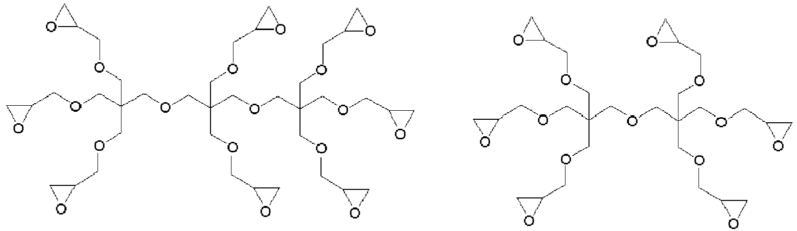

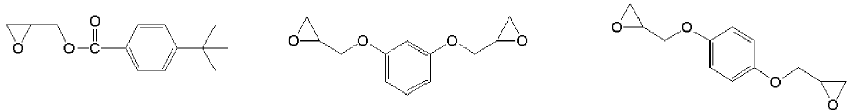

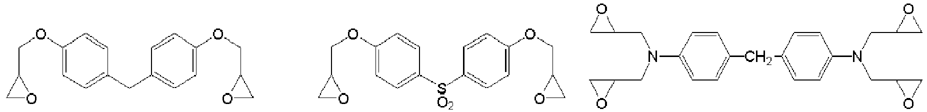

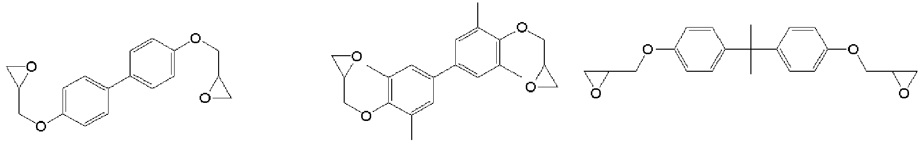

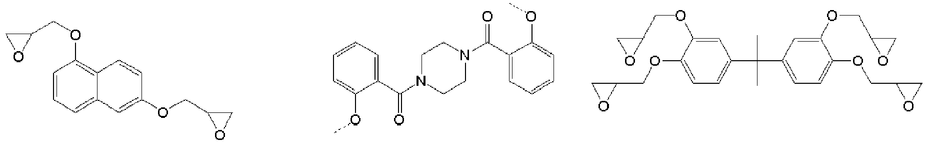

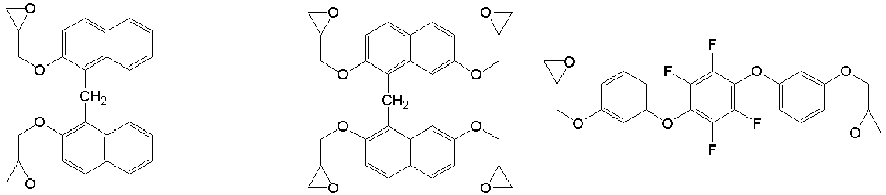

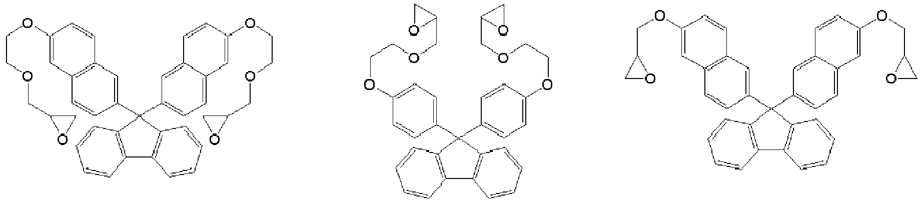

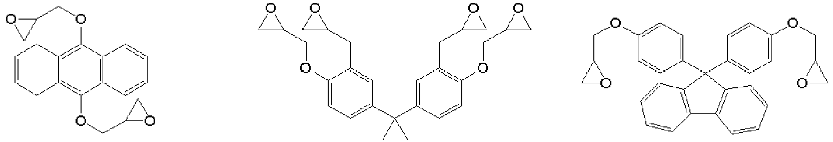

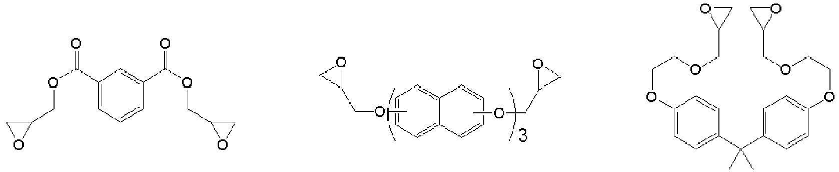

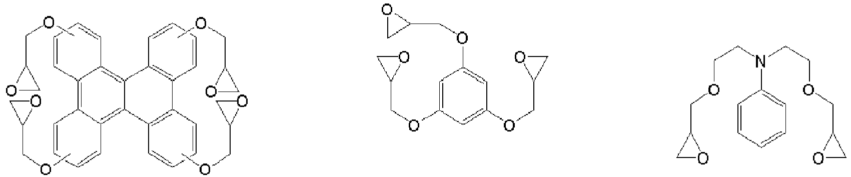

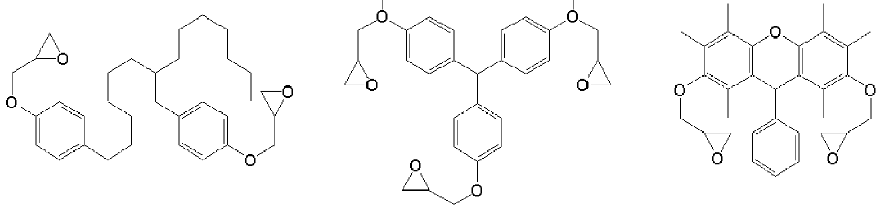

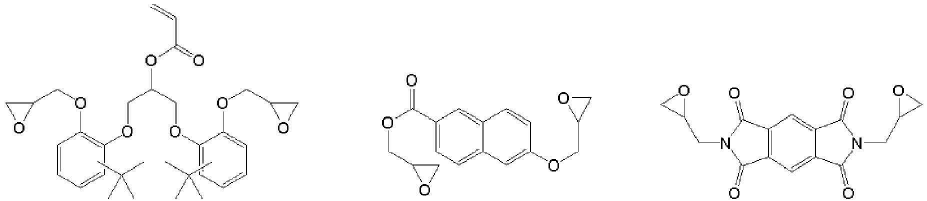

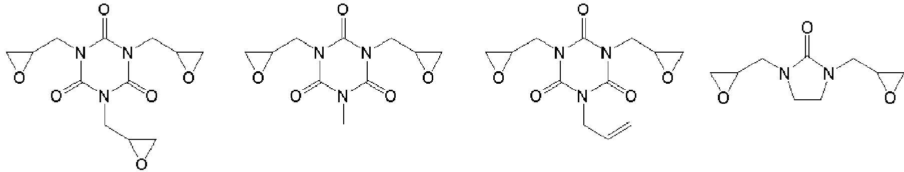

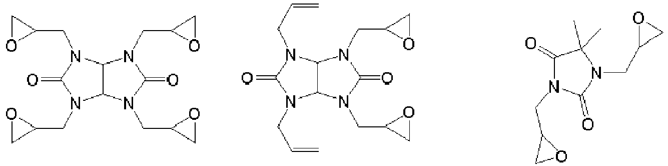

The compounds shown above can be purchased, but a compound containing one or more of epoxy, oxetane, and hydroxy groups can also be obtained by ring-opening a compound shown above with water or by allowing a hydroxy group to react with epibromohydrin, 3-bromomethyloxetane, etc. as in the following formula. In this event, by controlling the equivalent, the contained amounts of the epoxy and/or oxetane and the hydroxy groups can be adjusted. In the following formula, W represents a substituted or unsubstituted saturated monovalent organic group having 1 to 20 carbon atoms, a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms. Furthermore, the contained amounts of the epoxy and oxetane groups and the hydroxy groups preferably satisfy "the total number of epoxy and oxetane groups" > "the number of hydroxy groups", more preferably "the total number of epoxy and oxetane groups" > "the number of hydroxy groups × 2". This compound (D) is preferably contained in an amount of 5 to 50 parts by mass, more preferably 10 to 40 parts by mass based on 100 parts by mass of the compound (A) for forming a metal-containing film.

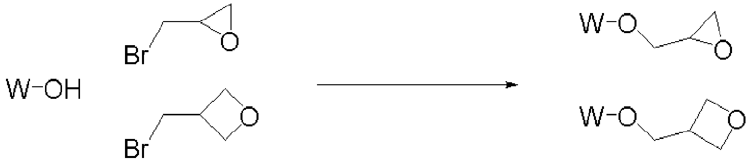

Specific examples of compounds having a hydroxy group that can be used in the above reaction include the following, but are not limited thereto.

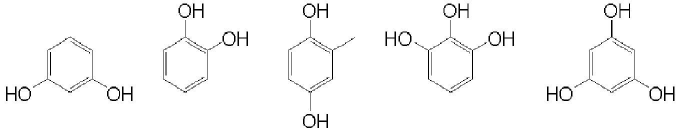

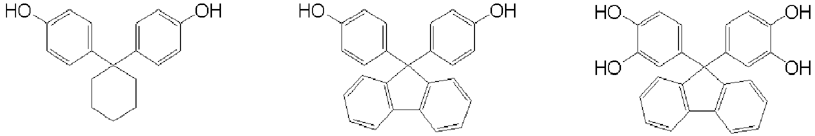

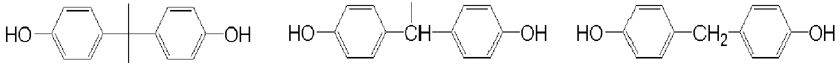

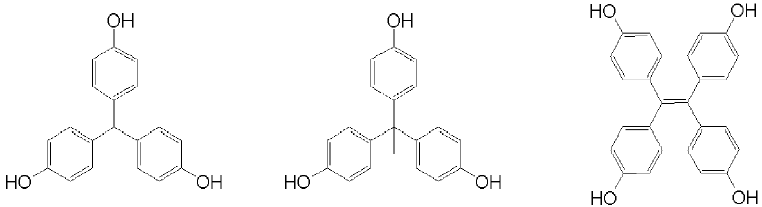

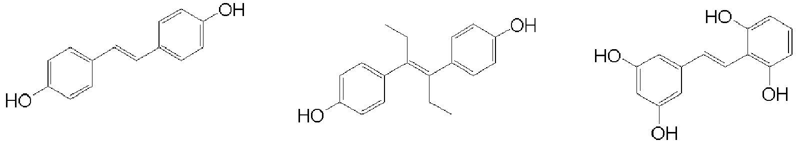

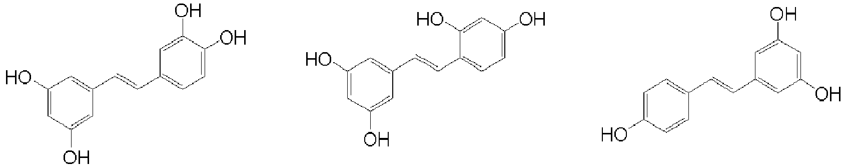

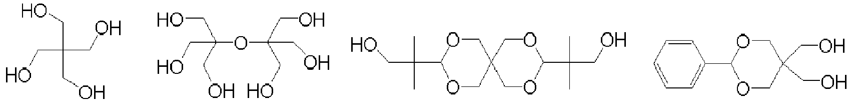

The epoxy and the oxetane in the above-described specific examples function as curable functional groups. Specifically, the groups react with hydroxy groups and carboxyl groups that are generated by baking the compound for forming a metal-containing film, and thus, can promote curing. Meanwhile, the hydroxy groups not only function as curable functional groups, but also function as adhesive groups. Specifically, it is assumed that adhesiveness is enhanced by these structures interacting with a silicon-containing middle layer film and a resist upper layer film through hydrogen bonds or the like.

Regarding the polymer, specifically, when the polymer includes one or more each of repeating units represented by the following general formulae (XL-1) or (XL-2), the molar fraction of the repeating units represented by the following general formulae (XL-1) and/or (XL-2) to all the repeating units is 20% or more and 90% or less, and the molar fraction of structural units represented by the general formulae (XL-1) and/or (XL-2) does not reach a total of 100%, it is possible to use in combination, as another structural unit, a structural unit derived from α,β-unsaturated carboxylic acid esters, such as other acrylates, other methacrylates, other acrylic acid amides, other methacrylic acid amides, crotonates, maleates, and itaconates; α,β-unsaturated carboxylic acids, such as methacrylic acid, acrylic acid, maleic acid, and itaconic acid; acrylonitrile; methacrylonitrile; α,β-unsaturated lactones, such as 5,5-dimethyl-3-methylene-2-oxotetrahydrofuran; cyclic olefins, such as norbornene derivatives and tetracyclo[4.4.0.1^{2,5}.1^{7,10}]dodecene derivatives; α,β-unsaturated carboxylic acid anhydrides, such as maleic anhydride and itaconic anhydride; allyl ethers; vinyl ethers; vinyl esters; and vinyl silanes.

These polymers preferably have a weight-average molecular weight of 1,000 to 20,000 and GPC dispersity of 2.0 or less. In addition, these compounds are preferably contained in an amount of 5 to 50 parts by mass, more preferably 10 to 40 parts by mass based on 100 parts by mass of the compound (A) for forming a metal-containing film.

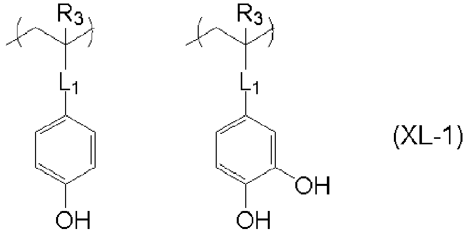

In the formulae, R₃ represents a hydrogen atom or a methyl group; and L₁ represents a single bond, a divalent organic group containing -C(=O)O-, or a divalent organic group containing -C(=O)NX-. X represents a hydrogen atom or a linear or branched alkyl group having 1 to 3 carbon atoms. 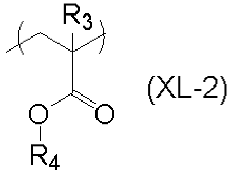 In the formula, R₃ represents a hydrogen atom or a methyl group; and R₄ represents a group selected from the following formulae (2-1) to (2-3). 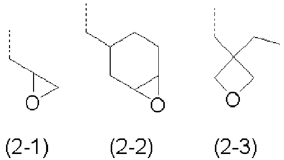 In the formulae, a broken line represents an attachment point.

The structural unit represented by the general formulae (XL-1) functions as a crosslinking group and an adhesive group. Specifically, it is thought that the hydroxy groups on the ends of the catechol group undergo a crosslinking reaction with tin, enhancing curability, and interact with a silicon-containing middle layer film and a resist upper layer film by a hydrogen bond or the like, enhancing adhesiveness. Meanwhile, the structural units represented by the general formulae (2-1) to (2-3) function as curing agents. Specifically, it is thought that curing is promoted by epoxy and oxetane reacting with hydroxy groups and/or carboxyl groups generated by baking a compound for forming a metal-containing film.

### [(E) Crosslinking Agent]

To increase the density of the film and further inhibit intermixing with the resist upper layer film, the inventive composition for forming a metal-containing film may further contain a crosslinking agent (E). The crosslinking agent is not particularly limited, and various known crosslinking agents can be widely used. Examples include melamine-based crosslinking agents, acrylate-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, and phenol-based crosslinking agents (e.g. polynuclear phenol-based, such as methylol or alkoxymethyl-based crosslinking agents). The crosslinking agent (E) is preferably contained in an amount of 5 to 50 parts by mass, more preferably 10 to 40 parts by mass relative to 100 parts by mass of the compound (A) for forming a metal-containing film.

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the acrylate-based crosslinking agents include dipentaerythritol hexaacrylate.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate] .

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the polynuclear phenol-based crosslinking agents include compounds represented by the following general formula (XL-3). 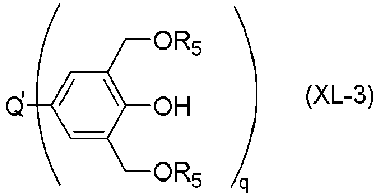 In the formula, Q' represents a single bond or a q-valent hydrocarbon group having 1 to 20 carbon atoms. R₅ represents a hydrogen atom or an alkyl group having 1 to 20 carbon atoms. "q" represents an integer of 1 to 5.

Q' represents a single bond or a hydrocarbon group having a valency of "q" and having 1 to 20 carbon atoms. "q" represents an integer of 1 to 5, more preferably 2 or 3. Specific examples of Q' include groups obtained by removing "q" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R₅ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. Among these, a hydrogen atom or a methyl group is preferable.

Specific examples of the compounds represented by the general formula (XL-3) include the following compounds. Among these, triphenolmethane, triphenolethane, 1,1,1-tris(4-hydroxyphenyl)ethane, and a hexamethoxymethylated derivative of tris(4-hydroxyphenyl)-1-ethyl-4-isopropylbenzene are preferable from the viewpoint of improving the curability and film thickness uniformity of the organic film. R₅ is as defined above.

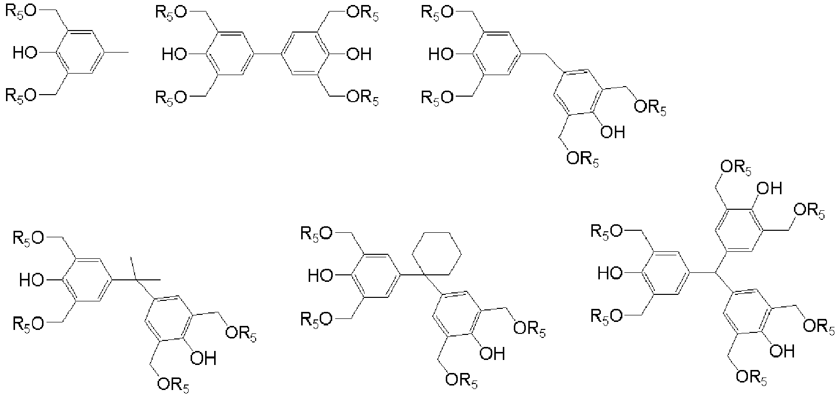

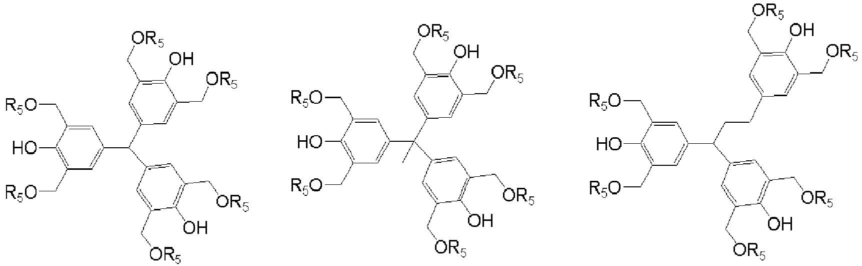

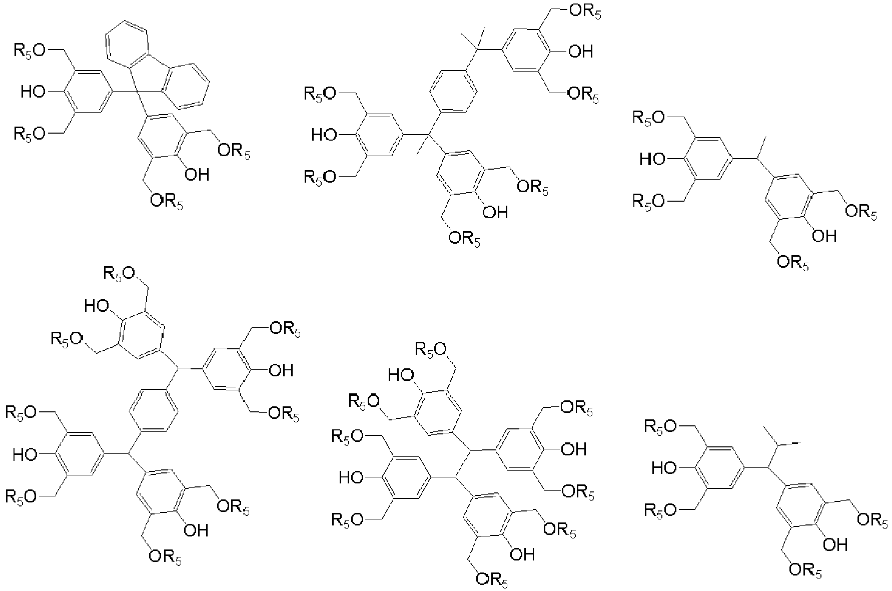

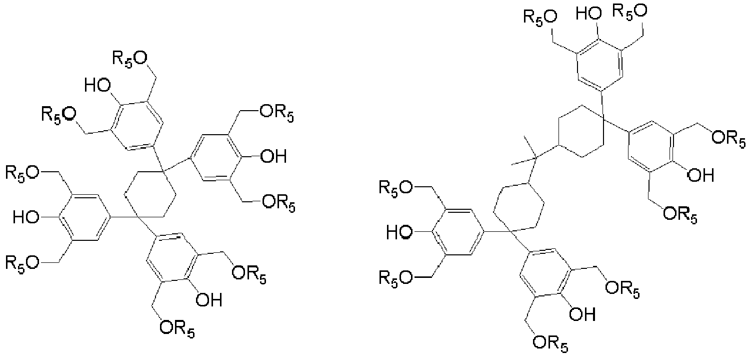

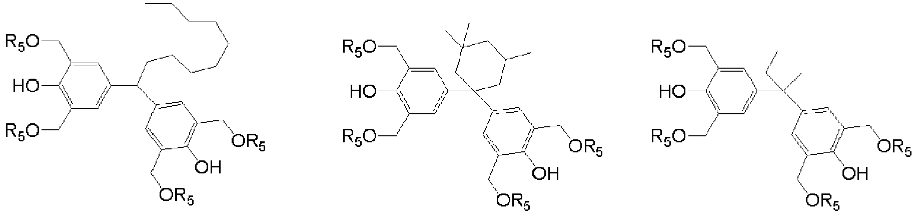

### <(F) Surfactant>

A surfactant (F) may be contained in the inventive composition for forming a metal-containing film in order to improve coating property in spin-coating. Examples of the surfactant include those disclosed in paragraphs [0142] to [0147] of JP2009-269953A. When the surfactant is contained, the contained amount is preferably 0.01 to 10 parts, more preferably 0.05 to 5 parts per 100 parts by mass of the compound (A) for forming a metal-containing film.

### <(G) Flowability Accelerator>

Another compound or polymer may be further blended in the inventive composition for forming a metal-containing film. The flowability accelerator is mixed with the inventive compound for forming a metal-containing film and serves to improve the film-formability by spin-coating and the filling property for a stepped substrate. Furthermore, as the flowability accelerator, a material having a high density of carbon atoms and high etching resistance is preferable.

Examples of such a material include novolak resins of phenol, o-cresol, m-cresol, p-cresol, 2,3-dimethyl phenol, 2,5-dimethylphenol, 3,4-dimethylphenol, 3,5-dimethylphenol, 2,4-dimethylphenol, 2,6-dimethylphenol, 2,3,5-trimethylphenol, 3,4,5-trimethylphenol, 2-tert-butylphenol, 3-tert-butylphenol, 4-tert-butylphenol, 2-phenylphenol, 3-phenylphenol, 4-phenylphenol, 3,5-diphenylphenol, 2-naphthylphenol, 3-naphthylphenol, 4-naphthylphenol, 4-tritylphenol, resorcinol, 2-methylresorcinol, 4-methylresorcinol, 5-methylresorcinol, catechol, 4-tert-butylcatechol, 2-methoxyphenol, 3-methoxyphenol, 2-propylphenol, 3-propylphenol, 4-propylphenol, 2-isopropylphenol, 3-isopropylphenol, 4-isopropylphenol, 2-methoxy-5-methylphenol, 2-tert-butyl-5-methylphenol, pyrogallol, thymol, isothymol, 4,4'-(9H-fluorene-9-ylidene)bisphenol, 2,2'-dimethyl-4,4'-(9H-fluorene-9-ylidene)bisphenol, 2,2'-diallyl-4,4'-(9H-fluorene-9-ylidene)bisphenol, 2,2'-difluoro-4,4'-(9H-fluorene-9-ylidene)bisphenol, 2,2'-diphenyl-4,4'-(9H-fluorene-9-ylidene)bisphenol, 2,2'-dimethoxy-4,4'-(9H-fluorene-9-ylidene)bisphenol, 2,3,2',3'-tetrahydro-(1,1')-spirobiindene-6,6'-diol, 3,3,3',3'-tetramethyl-2,3,2',3'-tetrahydro-(1,1')-spirobiindene-6,6'-diol, 3,3,3',3',4,4'-hexamethyl-2,3,2',3'-tetrahydro-(1,1')-spirobiindene-6, 6'-diol, 2,3,2',3'-tetrahydro-(1,1')-spirobiindene-5,5'-diol, 5,5'-dimethyl-3,3,3',3'-tetramethyl-2,3,2',3'-tetrahydro-(1,1')-spirobiindene-6,6'-diol, 1-naphthol, 2-naphthol, 2-methyl-1-naphthol, 4-methoxy-1-naphthol, and 7-methoxy-2-naphthol, dihydroxynaphthalene such as 1,5-dihydroxynaphthalene, 1,7-dihydroxynaphthalene, and 2,6-dihydroxynaphthalene, methyl-3-hydroxynaphthalene-2-carboxylate, indene, hydroxyindene, benzofuran, hydroxyanthracene, acenaphthylene, biphenyl, bisphenol, trisphenol, dicyclopentadiene, tetrahydroindene, 4-vinylcyclohexene, norbornadiene, 5-vinylnorborna-2-ene, α-pinene, β-pinene, or limonene; polyhydroxystyrene, polystyrene, polyvinylnaphthalene, polyvinylanthracene, polyvinylcarbazole, polyindene, polyacenaphthylene, polynorbornene, polycyclodecene, polytetracyclododecene, polynortricyclene, poly(meth)acrylate, and copolymers thereof. In addition, the composition may contain a naphthol dicyclopentadiene copolymer disclosed in JP2004-205685A, a fluorene bisphenol novolak resin disclosed in JP2005-128509A, an acenaphthylene copolymer disclosed in JP2005-250434A, fullerene having a phenolic group disclosed in JP2006-227391A, a bisphenol compound and a novolak resin thereof disclosed in JP2006-293298A, a novolak resin of an adamantane phenol compound disclosed in JP2006-285095A, a bisnaphthol compound and a novolak resin thereof disclosed in JP2010-122656A, a fluorene compound disclosed in JP2017-119671A, a fullerene resin compound disclosed in JP2008-158002A, and the like. The flowability accelerator is preferably contained in an amount of 0.001 to 100 parts by mass, more preferably 0.01 to 50 parts by mass based on 100 parts by mass of the inventive compound for forming a metal-containing film.

### <Other Additives>

In addition, in the inventive composition for forming a metal-containing film, it is preferable to use, as an additive for imparting filling and planarizing properties, for example, a liquid additive having a polyethylene glycol or polypropylene glycol structure, or a thermo-decomposable polymer having a weight reduction rate of 40% by mass or more on heating from 30°C to 250°C and a weight-average molecular weight of 300 to 200,000. This thermo-decomposable polymer preferably contains a repeating unit having an acetal structure represented by the following general formula (DP1) or (DP1a). 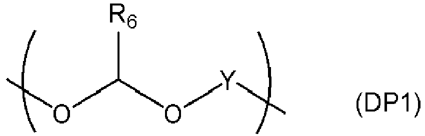 In the formula, R₆ represents a hydrogen atom or a substituted or unsubstituted, saturated or unsaturated monovalent organic group having 1 to 30 carbon atoms. Y represents a saturated or unsaturated divalent organic group having 2 to 30 carbon atoms. 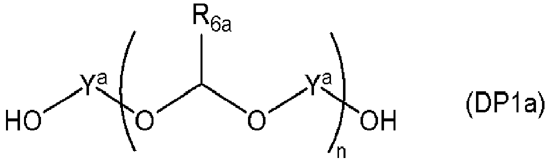 In the formula, R₆ₐ represents an alkyl group having 1 to 4 carbon atoms. Y^{a} represents a saturated or unsaturated divalent hydrocarbon group having 4 to 10 carbon atoms and optionally having an ether bond. "n" represents an average repeating unit number of 3 to 500.

### <Method for Forming Metal-Containing Film>

The present invention provides a method of forming, by using the above-described composition for forming a metal-containing film, a metal-containing film. For example, it is possible to form, as a metal-containing film, a resist underlayer film of a multilayer resist film used in lithography or a filling film that serves as a planarizing film for the manufacture of semiconductor.

In a method for forming a resist underlayer film by using the inventive composition for forming a metal-containing film, the substrate to be processed is coated with the above-described composition for forming a metal-containing film by a spin-coating method or the like. Using the spin-coating method or the like ensures a desirable filling property. After spin-coating, baking (heating) is performed so as to evaporate the solvent and promote a crosslinking reaction to prevent mixing with the resist upper layer film and the resist middle layer film. The baking is preferably performed at a temperature of 100°C or higher and 600°C or lower for 10 to 600 seconds, more preferably at a temperature of 200°C or higher and 500°C or lower for 10 to 300 seconds. In consideration of influences on device damage, wafer deformation, and the like, the upper limit of the heating temperature in the wafer process of lithography is preferably not more than 600°C, and more preferably not more than 500°C.

Furthermore, in the method for forming a resist underlayer film where the inventive composition for forming a metal-containing film is used, a substrate to be processed may be coated with the inventive composition for forming a metal-containing film by spin-coating or the like in the same manner as described above, and then the composition for forming a metal-containing film may be baked and cured under an atmosphere having an oxygen concentration of 0.1 volume % or more and 21 volume % or less to form a metal-containing film as a resist underlayer film.

By baking the inventive composition for forming a metal-containing film in such an oxygen atmosphere, a sufficiently cured film can be obtained. The atmosphere during baking may be air; however, to prevent oxidation of the metal-containing film, it is preferable to enclose an inert gas, such as N₂, Ar, or He, therein to reduce the amount of oxygen. Control of oxygen concentration is necessary to prevent oxidation; the oxygen concentration is preferably 1000 ppm or less, more preferably 100 ppm or less (volumetric basis). By thus preventing oxidation of the metal-containing film during the baking, the absorption does not increase and the etching resistance does not decrease, which is preferable.

### <Patterning Process Using Composition for Forming Metal-Containing Film>

The present invention provides, as a patterning process according to a two-layer resist process using the above-described composition for forming a metal-containing film, a patterning process for forming a pattern in a substrate to be processed, including the steps of:
(I-1) applying the inventive composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

The resist upper layer film in the two-layer resist process described above exhibits etching resistance with respect to chlorine-based gas. Therefore, the dry etching of the metal-containing film that is performed while using the resist upper layer film as a mask in the two-layer resist process is preferably performed by using an etching gas mainly containing a chlorine-based gas.

The present invention provides, as a patterning process according to a three-layer resist process using the above-described composition for forming a metal-containing film, a patterning process for forming a pattern in a substrate to be processed, including the steps of:
(II-1) applying the inventive composition for forming a metal-containing film onto a substrate to be processed, followed by heating to form a metal-containing film;
(II-2) forming a silicon-containing resist middle layer film on the metal-containing film;
(II-3) forming a resist upper layer film on the silicon-containing resist middle layer film by using a photoresist material;
(II-4) subjecting the resist upper layer film to pattern exposure and then development with a developer to form a pattern in the resist upper layer film;
(II-5) transferring the pattern to the silicon-containing resist middle layer film by dry etching while using the resist upper layer film having the formed pattern as a mask;
(II-6) transferring the pattern to the metal-containing film by dry etching while using the silicon-containing resist middle layer film having the transferred pattern as a mask; and
(II-7) processing the substrate to be processed while using the metal-containing film having the formed pattern as a mask to form the pattern in the substrate to be processed.

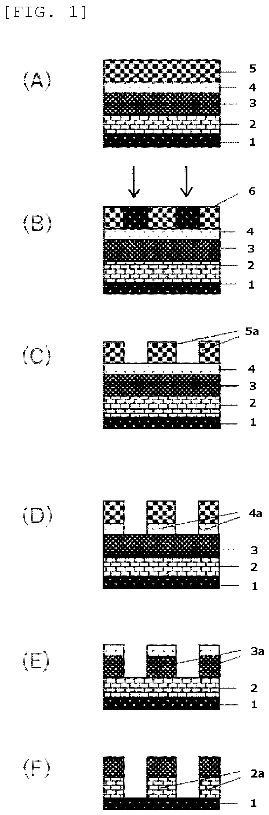

With reference to FIG. 1, a patterning process according to a three-layer resist process will be described. The present invention provides, as a patterning process according to a three-layer resist process using such a composition for forming a metal-containing film, the patterning process including:
forming a metal-containing film 3 on a layer 2 to be processed on a substrate 1 to be processed by using the composition for forming a metal-containing film, forming a silicon-containing resist middle layer film 4 on the metal-containing film 3 by using a silicon-containing resist middle layer film material, and forming a resist upper layer film 5 on the silicon-containing resist middle layer film 4 by using a photoresist material, as in FIG. 1(A);
subsequently subjecting an exposure portion 6 of the resist upper layer film to pattern exposure as in FIG. 1(B), and then development with a developer to form a resist upper layer film pattern 5a in the resist upper layer film as in FIG. 1(C);
transferring a silicon-containing resist middle layer film pattern 4a to the silicon-containing resist middle layer film by dry etching while using the resist upper layer film having the formed pattern as a mask as in FIG. 1(D);
transferring a metal-containing film pattern 3a to the metal-containing film by dry etching while using the silicon-containing resist middle layer film having the transferred pattern as a mask as in FIG. 1(E); and
processing the layer to be processed on the substrate to be processed while using the metal-containing film having the formed pattern as a mask to form a pattern 2a on the substrate 1 to be processed as in FIG. 1(F).

The silicon-containing resist middle layer film in the three-layer resist process exhibits etching resistance with respect to a chlorine-based gas and a hydrogen-based gas. Therefore, the dry etching of the metal-containing film that is performed while using the silicon-containing resist middle layer film as a mask in the three-layer resist process is preferably performed by using an etching gas mainly containing a chlorine-based gas or a hydrogen-based gas.

As the silicon-containing resist middle layer film in the three-layer resist process, a polysiloxane-based middle layer film is also favorably used. This allows the silicon-containing resist middle layer film to possess an effect as an antireflective film, thereby suppressing reflection. When a material containing many aromatic groups and having a high etching selectivity with respect to the substrate is used as the organic film especially for 193-nm exposure, the k-value increases and thus the substrate reflection increases; however, the reflection can be suppressed by imparting absorption so that the silicon-containing resist middle layer film has an appropriate k-value. In this manner, the substrate reflection can be reduced to 0.5% or less. Preferably used as the silicon-containing resist middle layer film having an antireflective effect is a polysiloxane, which has an anthracene for exposure at 248 nm or 157 nm, or a pendant phenyl group or a pendant light-absorbing group having a silicon-silicon bond for 193 nm exposure, and which is cross-linked by an acid or heat.

In addition, the present invention provides, as a patterning process by way of a four-layer resist process using such a composition for forming a metal-containing film, a patterning process including the steps of:
forming a metal-containing film on a substrate to be processed by using the inventive composition for forming a metal-containing film;
forming a silicon-containing resist middle layer film on the metal-containing film by using a silicon-containing resist middle layer film material;
forming an organic antireflective coating (BARC) or an adhesive film on the silicon-containing resist middle layer film;
forming a resist upper layer film on the BARC or the adhesive film by using a photoresist material;
subjecting the resist upper layer film to pattern exposure and then development with a developer, thereby forming a pattern in the resist upper layer film;
transferring the pattern to the BARC or the adhesive film and the silicon-containing resist middle layer film by dry etching while using the resist upper layer film having the formed pattern as a mask;
transferring the pattern to the metal-containing film by dry etching while using the silicon-containing resist middle layer film having the transferred pattern as a mask; and
processing the substrate to be processed while using the metal-containing film having the formed pattern as a mask, thereby forming the pattern in the substrate to be processed.

Alternatively, an inorganic hard mask may be formed instead of the silicon-containing resist underlayer film. In this case, a semiconductor device circuit pattern can be formed on a substrate, at least, by:
forming a metal-containing film on a body to be processed (substrate to be processed) by using the inventive composition for forming a metal-containing film;
forming an inorganic hard mask middle layer film selected from the group consisting of a silicon oxide film, a silicon nitride film, and a silicon oxynitride film on the metal-containing film;
forming a resist upper layer film on the inorganic hard mask middle layer film by using a photoresist composition;
forming a circuit pattern in the resist upper layer film;
transferring the pattern to the inorganic hard mask middle layer film while using the resist upper layer film having the formed pattern as a mask;
transferring the pattern to the metal-containing film while using the inorganic hard mask middle layer film having the formed pattern as a mask; and
further transferring the pattern to the body to be processed while using the metal-containing film having the formed pattern as a mask to form the pattern in the body to be processed.

The present invention provides, as a patterning process according to a four-layer resist process using the above-described composition for forming a metal-containing film, a patterning process for forming a pattern in a substrate to be processed, including the steps of:
(III-1) applying the above-described composition for forming a metal-containing film onto a substrate to be processed, followed by heating to form a metal-containing film;
(III-2) forming an inorganic hard mask middle layer film selected from the group consisting of a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

As described above, when the inorganic hard mask middle layer film is formed on the metal-containing film, a silicon oxide film, a silicon nitride film, and a silicon oxynitride film (SiON film) can be formed by a CVD method, an ALD method, etc. The method for forming the silicon nitride film is disclosed, for example, in JP2002-334869A and WO2004/066377A1. The film thickness of the inorganic hard mask middle layer film is preferably 5 to 200 nm, more preferably 10 to 100 nm. The SiON film, which has a high function as an antireflective film, is the most preferably used as the inorganic hard mask middle layer film. Since the substrate temperature increases to 300 to 500°C when the SiON film is formed, the metal-containing film needs to withstand a temperature of 300 to 500°C. The composition for forming a metal-containing film used in the present invention has high heat resistance and can withstand a high temperature of 300 to 500°C. Thus, the metal-containing film formed by spin-coating and the inorganic hard mask middle layer film formed by the CVD method or the ALD method can be combined.

A photoresist film may be formed on the inorganic hard mask middle layer film as the resist upper layer film as described above. Alternatively, an organic antireflective coating (BARC) or an adhesive film may be formed on the inorganic hard mask middle layer film by spin-coating, and a photoresist film may be formed thereon. In particular, when a SiON film is used as the inorganic hard mask middle layer film, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

In addition, in the present invention, a semiconductor device circuit pattern can be formed on a substrate by a patterning process according to a multilayer resist process using the above-described composition for forming a metal-containing film, the process including:
forming a resist underlayer film on a substrate to be processed;
applying the inventive composition for forming a metal-containing film onto the resist underlayer film, followed by heating to form a metal-containing film;
forming a resist upper layer film on the metal-containing film by using a photoresist material;
subjecting the resist upper layer film to pattern exposure and then development with a developer to form a patter in the resist upper layer film;
transferring the pattern to the metal-containing film by dry etching while using the resist upper layer film having the formed pattern as a mask;
transferring the pattern to the resist underlayer film by dry etching while using the metal-containing film having the transferred pattern as a mask; and
further processing the substrate to be processed while using the resist underlayer film having the formed pattern as a mask to form the pattern in the substrate to be processed.

A photoresist film may be formed on the metal-containing film as a resist upper layer film as described above. Alternatively, an organic adhesive film may be formed on the metal-containing film by spin-coating, and a photoresist film may be formed thereon.

That is, the present invention provides a patterning process according to a multilayer resist process using such a composition for forming a metal-containing film. In this case, a semiconductor device circuit pattern can be formed on a substrate to be processed by a patterning process for forming a pattern in a substrate to be processed, including the steps of:
(IV-1) forming a resist underlayer film on a substrate to be processed;
(IV-2) applying the above-described composition for forming a metal-containing film onto the resist underlayer film, followed by heating to form a metal-containing film;
(IV-3) forming a resist upper layer film on the metal-containing film by using a photoresist material or forming an organic adhesive film on the metal-containing film by spin-coating and forming a resist upper layer film on the organic adhesive film by using a photoresist material;
(IV-4) subjecting the resist upper layer film to pattern exposure and then development with a developer to form a pattern in the resist upper layer film;
(IV-5) transferring the pattern to the organic adhesive film and the metal-containing film or the metal-containing film by dry etching while using the resist upper layer film having the formed pattern as a mask;
(IV-6) transferring the pattern to the resist underlayer film by dry etching while using the metal-containing film having the transferred pattern as a mask; and
(IV-7) processing the substrate to be processed while using the resist underlayer film having the formed pattern as a mask to form the pattern in the substrate to be processed.

As described above, when the resist underlayer film is formed on the substrate to be processed, the resist underlayer film can be formed by a method using a coating-type resist underlayer film material, a CVD method, an ALD method, or the like. Examples of the coating-type organic underlayer film material include resins and compositions disclosed in JP2012-001687A, JP2012-077295A, JP2004-264710A, JP2005-043471A, JP2005-250434A, JP2007-293294A, JP2008-065303A, JP2004-205685A, JP2007-171895A, JP2009-014816A, JP2007-199653A, JP2008-274250A, JP2010-122656A, JP2012-214720A, JP2014-029435A, WO2012/077640A1, WO2010/147155A1, WO2012/176767A1, JP2005-128509A, JP2006-259249A, JP2006-259482A, JP2006-293298A, JP2007-316282A, JP2012-145897A, JP2017-119671A, JP2019-044022A, etc.

The resist upper layer film in the multilayer resist process described above may be either a positive type or a negative type, and it is possible to use a film similar to the typically used photoresist composition. The prebaking, which is conducted after the spin-coating with the photoresist composition, is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 30 to 500 nm, particularly preferably 50 to 400 nm.

Furthermore, examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

Next, etching is performed while using the obtained resist pattern as a mask. The etching of a silicon-containing resist middle layer film or an inorganic hard mask middle layer film in the three-layer resist process is performed while using the resist upper layer film pattern as a mask by using a fluorocarbon-based gas. In this manner, a silicon-containing resist middle layer film pattern or an inorganic hard mask middle layer film pattern is formed.

Next, the metal-containing film is etched while using the obtained silicon-containing resist middle layer film pattern or inorganic hard mask middle layer film pattern as a mask. The etching of the metal-containing film is preferably performed by using an etching gas mainly containing a chlorine-based gas.

The subsequent etching of a body to be processed may also be performed according to a usual manner. For example, in the case of a body to be processed made of SiO₂, SiN or silica-based insulating film having a low dielectric constant, the etching is performed mainly based on a fluorocarbon-based gas. When the substrate is processed by way of etching with a fluorocarbon-based gas, the silicon-containing resist middle layer film pattern in the three-layer resist process is stripped simultaneously with the substrate processing.

The metal-containing film obtained by using the inventive composition for forming a metal-containing film is characterized by its excellent etching resistance at the time of etching of the body to be processed.

Examples of the body to be processed (substrate to be processed) include, but are not particularly limited to, substrates made of Si, α-Si, p-Si, SiO₂, SiN, SiON, W, TiN, Al, etc., those in which the layers to be processed are formed on the substrate, and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

In the patterning process using the inventive composition for forming a metal-containing film, it is preferable to use a substrate to be processed having a structure or step having a height of 30 nm or more. As described above, the inventive composition for forming a metal-containing film has excellent filling and planarizing properties, so that a flat metal-containing film can be formed even when the substrate to be processed has a step (irregularities) or structure having a height of 30 nm or more. The height of the structure or step of the substrate to be processed is preferably 30 nm or more, more preferably 50 nm or more, and more preferably 100 nm or more. In the method of processing a stepped substrate having a pattern of the above-described height, filling and planarizing by forming a film of the inventive composition for forming a metal-containing film makes it possible to achieve a uniform film thickness in the subsequently formed resist middle layer film and resist upper layer film. Therefore, it is easy to ensure the exposure depth margin (DOF) at the time of photolithography, which is very desirable.

### <Tone-Reversal Patterning Process Using Composition for Forming Metal-Containing Film>

Furthermore, the present invention provides, as a tone-reversal patterning process using the inventive composition for forming a metal-containing film described above, a tone-reversal patterning process for forming a pattern in a substrate to be processed, including the steps of:
(V-1) forming a resist underlayer film on a substrate to be processed;
(V-2) forming a resist middle layer film or a combination of an organic thin film and an inorganic hard mask middle layer film selected from the group consisting of a silicon oxide film, a silicon nitride film, and a silicon oxynitride film on the resist underlayer film;
(V-3) forming a resist upper layer film on the resist middle layer film or the combination of the organic thin film and the inorganic hard mask middle layer film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film having the transferred pattern or the inorganic hard mask middle layer film having the transferred pattern as a mask;
(V-7) applying the inventive composition for forming a metal-containing film onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing the resist underlayer film having the formed pattern with its surface exposed by dry etching to form a reverse pattern of an original pattern on the metal-containing film; and
(V-11) processing the substrate to be processed while using the metal-containing film having the formed reverse pattern as a mask to form the reverse pattern in the substrate to be processed.

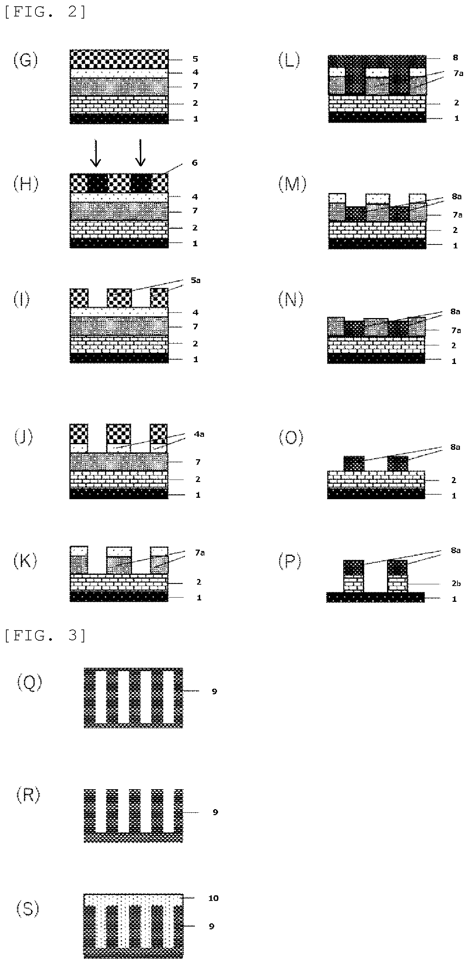

With reference to FIG. 2, a tone-reversal patterning process using a composition for forming a metal-containing film will be described. The present invention provides, as a tone-reversal patterning process using such a composition for forming a metal-containing film, a tone-reversal patterning process including the steps of:
forming a resist underlayer film 7 on a layer 2 to be processed on a substrate 1 to be processed, forming a resist middle layer film 4 or a combination of an organic thin film and an inorganic hard mask middle layer film selected from the group consisting of a silicon oxide film, a silicon nitride film, and a silicon oxynitride film on the resist underlayer film 7, and forming a resist upper layer film 5 on the resist middle layer film 4 or the combination of the organic thin film and the inorganic hard mask middle layer film by using a photoresist material, as in FIG. 2(G);
subsequently subjecting an exposure portion 6 of the resist upper layer film to pattern exposure as in FIG. 2(H), and then development with a developer to form a resist upper layer film pattern 5a in the resist upper layer film as in FIG. 2(I);
transferring a resist middle layer film pattern 4a or an inorganic hard mask middle layer film pattern to the resist middle layer film or the organic thin film and the inorganic hard mask middle layer film by dry etching while using the resist upper layer film having the formed pattern as a mask as in FIG. 2(J);
transferring a resist underlayer film pattern 7a to the resist underlayer film by dry etching while using the resist middle layer film or the inorganic hard mask middle layer film having the transferred pattern as a mask as in FIG. 2(K);
covering the resist underlayer film having the formed pattern with a metal-containing film 8 by using the above-described composition for forming a metal-containing film, thereby filling a space between the resist underlayer film patterns 7a with the metal-containing film 8 as in FIG. 2(L);
etching back the metal-containing film covering the resist underlayer film having the formed pattern by a chemical stripper or dry etching to form a reversed metal-containing film pattern 8a to expose an upper surface of the resist underlayer film having the formed pattern as in FIG. 2(M);
removing the resist middle layer film or the hard mask middle layer film remaining on the upper surface of the resist underlayer film pattern 7a by dry etching as in FIG. 2(N);
removing the resist underlayer film having the formed pattern with its surface exposed by dry etching to form a reverse pattern 8a of the original pattern in the metal-containing film as in FIG. 2(O); and
processing the layer to be processed while using the metal-containing film having the formed reverse pattern as a mask to form the reverse pattern 2b in the layer to be processed as in FIG. 2(P).

As described above, when the resist underlayer film is formed on the substrate to be processed, the resist underlayer film can be formed by a method using a coating-type resist underlayer film material, a CVD method, an ALD method, or the like. Examples of the coating-type resist underlayer film material include the resins and compositions given above.

In the tone-reversal patterning process, after the obtained resist underlayer film pattern is coated with the composition for forming a metal-containing film, it is preferable to remove the metal-containing film by using a dry etching gas mainly containing a chlorine-based gas so as to expose the upper surface of the resist underlayer film pattern. Thereafter, the resist middle layer film or the inorganic hard mask middle layer film remaining on the resist underlayer film is removed by dry etching using a fluorocarbon-based gas, and the resist underlayer film pattern having an exposed surface is removed by dry etching using an oxygen-based gas to form a metal-containing film pattern.

In the tone-reversal patterning process described above, the resist underlayer film pattern preferably has a step or a structure with a height of 30 nm or more. As described above, the inventive composition for forming a metal-containing film has excellent filling and planarizing properties. Thus, even when the film to be processed has a step (irregularities) or a structure with a height of 30 nm or more, a flat metal-containing film can be formed. The height of the structure or the step of the resist underlayer film pattern is preferably 30 nm or more, more preferably 50 nm or more, and still more preferably 100 nm or more. In the method of reversing the resist underlayer film pattern having a pattern with the above-described height, by performing filling and planarization by forming a film from the inventive composition for forming a metal-containing film, inversion/transfer of the pattern can be performed with a high degree of accuracy, which is very desirable. Reversing the resist underlayer film pattern by using the above-described composition for forming a metal-containing film allows a desired resist pattern to be formed on a film to be processed with a high degree of accuracy due to the excellence in resistance in dry etching using a fluorocarbon-based gas relative to the resist underlayer film obtained by using a previously-known coating-type resist underlayer film material.

### EXAMPLES

The present invention is more specifically described below with reference to Synthesis Examples, Comparative Synthesis Examples, Examples, and Comparative Examples. However, the present invention is not limited to these Examples. To obtain molecular weight and dispersity, weight-average molecular weight (Mw) and number-average molecular weight (Mn) on polystyrene basis were measured by gel permeation chromatography (GPC) using tetrahydrofuran as an eluent, and dispersity (Mw/Mn) was calculated from these values.

### [Synthesis Example]

In the following Synthesis Examples and Comparative Synthesis Examples, the following starting material group G ((G1) to (G14)) was used. The starting material group G ((G1) to (G14)) is shown below.

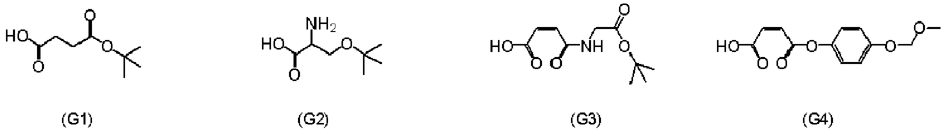

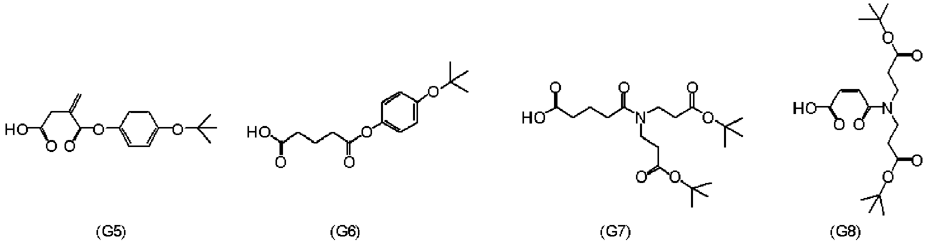

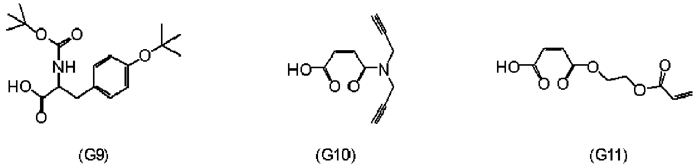

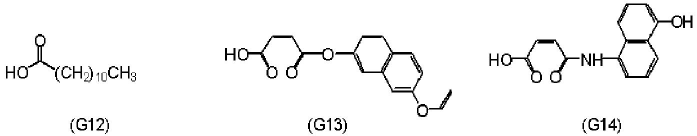

### [Synthesis Example 1] Synthesis of Compound (A-1) for Forming Metal-Containing Film

5.0 g of dibutyltin oxide, 7.0 g of a carboxylic acid (G1), and 100 g of toluene were added together, and refluxed for 7 hours while removing water. After the reaction, the solvent was removed under reduced pressure to give a compound (A-1) shown below.

(A-1): Mw = 322, Mw/Mn = 1.05

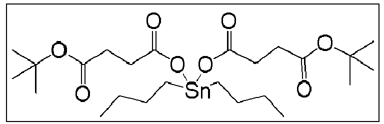

### [Synthesis Examples 2 to 11 and Comparative Synthesis Examples R1 to R3] Synthesis of Compounds (A-2) to (A-11) for Forming Metal-Containing Film and Compounds (R-1) to (R-3) for Forming Metal-Containing Film for Comparative Examples

The compounds (A-2) to (A-11) and the compounds (R-1) to (R-3) for the Comparative Examples shown in Tables 1 to 3 were obtained under the same reaction conditions as in Synthesis Example 1, except that the compound group G and a tin oxide compound were used at the charging amounts shown in Tables 1 to 3. The weight-average molecular weight (Mw) and the dispersity (Mw/Mn) of these compounds were determined. Table 4 shows the results.

**[Table 1]**

| Synthesis Example | Tin oxide compound | Compound group G | Compound or polymer |
|---|---|---|---|
| 1 | 5.0 g | G1 (7.0 g) | 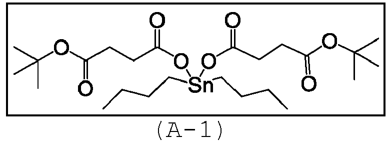 |
| 2 | 5.0 g | G2 (5.1 g) | 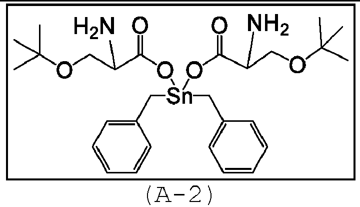 |
| 3 | 5.0 g | G3 (9.2 g) | 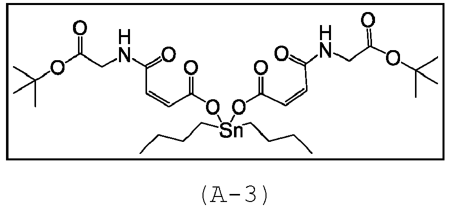 |
| 4 | 5.0 g | G4 (10.1 g) | 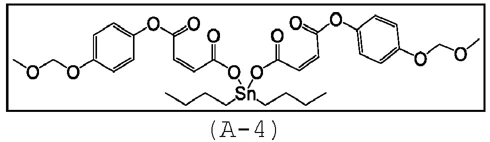 |
| 5 | 5.0 g | G5 (11.2 g) | 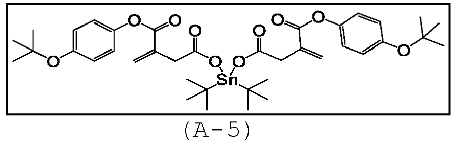 |
| 6 | 5.0 g | G6 (11.3 g) | 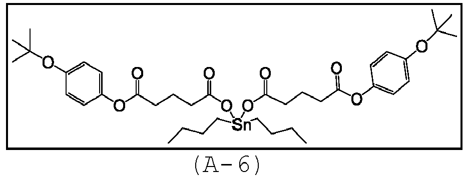 |
| 7 | 5.0 g | G7 (15.6 g) | 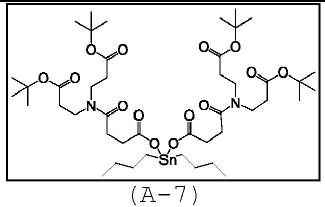 |

**[Table 2]**

| Synthesis Example | Tin oxide compound | Compound group G | Compound or polymer |
|---|---|---|---|
| 8 | 5.0 g | G8 (15.0 g) | 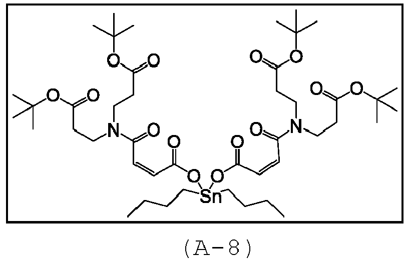 |
| 9 | 5.0 g | G9 (13.6 g) | 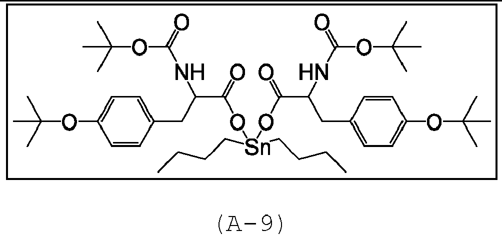 |
| 10 | 5.0 g | G1 (6.4 g) | 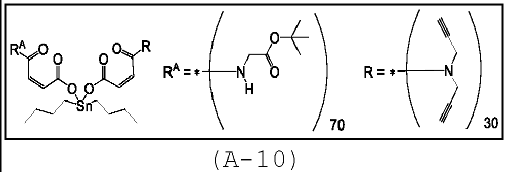 |
| | | G10 (2.3 g) | |
| 11 | 5.0 g | G1 (6.4 g) | 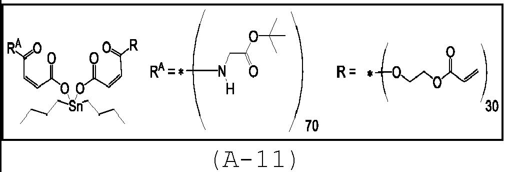 |
| | | G11 (2.6 g) | |

**[Table 3]**

| Comparative Synthesis Example | Tin oxide compound | Compound group G | Compound |
|---|---|---|---|
| 1 | 5.0 g | G12 (8.0 g) | 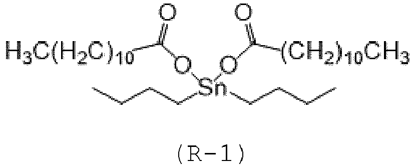 |
| 2 | 5.0 g | G13 (11.4 g) | 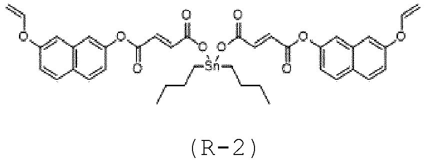 |
| 3 | 5.0 g | G14 (10.3 g) | 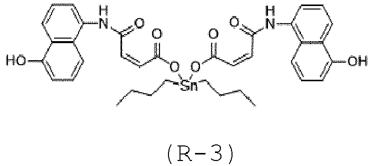 |

**[Table 4]**

| Compound | Mw | Mw/Mn |
|---|---|---|
| A-1 | 322 | 1.05 |
| A-2 | 331 | 1.09 |
| A-3 | 298 | 1.07 |
| A-4 | 329 | 1.12 |
| A-5 | 399 | 1.24 |
| A-6 | 410 | 1.05 |
| A-7 | 514 | 1.10 |
| A-8 | 361 | 1.08 |
| A-9 | 452 | 1.12 |
| A-10 | 304 | 1.43 |
| A-11 | 318 | 1.39 |
| R-1 | 336 | 1.03 |
| R-2 | 260 | 1.02 |
| R-3 | 251 | 1.01 |

### [Comparative Synthesis Example 4] Synthesis of Compound (R-4) for Forming Metal-Containing Film for Comparative

### Example

8.0 g of butyltin trichloride was stirred at room temperature, and 10 g of acrylic acid was dropped thereto. After that, the temperature was raised to 80°C, and the mixture was stirred for 7 hours. After the completion of the reaction, the acrylic acid was removed under reduced pressure, and the following compound (R-4) was obtained.
(R-4): Mw = 51, Mw/Mn = 1.14

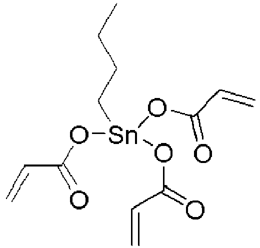

### [Comparative Synthesis Example 5] Synthesis of Compound (R-5) for Forming Metal-Containing Film for Comparative Example

As a compound having a different metal from the inventive compound for forming a metal-containing film, a titanium compound reported in [Synthesis Example A-II] of JP6189758B was synthesized according to the following procedure.

An IPA solution (500 g) of deionized water (27 g) was agitated with an IPA solution (500 g) of a titanium tetraisopropoxide (manufactured by Tokyo Chemical Industry Co., Ltd.) (284 g) and dropped at room temperature for 2 hours. 2-methyl-2,4-pentanediol (120 g) was added to a solution obtained and agitated at room temperature for 30 minutes. After the solution was concentrated under reduced pressure at 30°C, it was heated to 60°C and heating was continued under reduced pressure to generate no distillate. Then, PGMEA (propylene glycol monomethyl ether acetate) (1,200 g) was added thereto and heated under reduced pressure at 40°C until no IPA was distilled to obtain a PGMEA solution of a titanium-containing compound (R-5) (1,000 g) (compound concentration: 20 mass%). The molecular weight of the compound measured in terms of polystyrene was Mw = 1,100.

### [Synthesis of Resin (R-6) for Forming Organic Film for Comparative Example]

Under a nitrogen atmosphere, 160.2 g of 1,5-dihydroxynaphthalene, 56.8 g of formaldehyde, and 300 g of PGME (propylene glycol monomethyl ether) were added, and homogenized at an internal temperature of 100°C. After that, a mixed solution of 8.0 g of p-toluenesulfonic acid monohydrate and 8.0 g of PGME that had been mixed and homogenized beforehand was added dropwise slowly, and a reaction was allowed to take place at an internal temperature of 80°C for 8 hours. After the reaction was completed, the resultant was cooled to room temperature, and 2,000 ml of MIBK was added thereto. The resultant was washed six times with 500 ml of pure water, and the organic layer was evaporated under reduced pressure to dryness. After adding 300 g of THF to the residue to yield a homogeneous solution, a crystal was precipitated in 2,000 g of hexane. The precipitated crystal was separated by filtration, washed twice with 500 g of hexane, and collected. The collected crystal was vacuum-dried at 70°C, thereby obtaining a resin (R-6) shown below.

The weight-average molecular weight (Mw) and the dispersity (Mw/Mn) were determined by GPC, and the following results were obtained.
(R-6): Mw = 3,300, Mw/Mn = 2.54

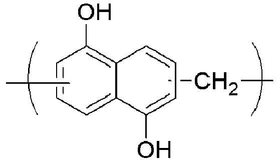

### [Preparation of Composition (UDL-1) for Forming Metal-Containing Film]

The compound (A-1) for forming a metal-containing film and the acid generator (C-1) shown below were dissolved at a ratio shown in Table 5 in cyclohexanone (CyHO) as an organic solvent (containing 0.5 mass% of FC-4430 (manufactured by Sumitomo 3M Limited) as a surfactant (F-1)), and the solution was filtered through a 0.02-µm membrane filter to prepare a composition (UDL-1) for forming a metal-containing film.

### [Preparation of Compositions (UDL-2 to -15) for Forming Metal-Containing Film and Compositions (Comparative UDL-1 to -6) for Forming Metal-Containing Film for Comparative Example]

Each composition for forming a metal-containing film was prepared according to the same procedure as the composition (UDL-1) for forming a metal-containing film, except that the type and the contained amount of each component were as shown in Table 5. In Table 5, "-" indicates that the component was not used.

The following formula (C-1) was used for the acid generator (TAG). The following formula (D-1) was used for a compound or a polymer containing one or more of epoxy, oxetane, and hydroxy groups. The following formula (E-1) was used for a crosslinking agent. 1,6-diacetoxyhexane (boiling point: 260°C) was used as a high-boiling-point solvent (B1-1). As a flowability accelerator (G), a polymer (G-1) for a flowability accelerator, synthesized according to the procedure shown later, was used.

### [Thermal Acid Generator (C-1)]

The thermal acid generator (C-1) used in a composition for forming a metal-containing film is shown below.

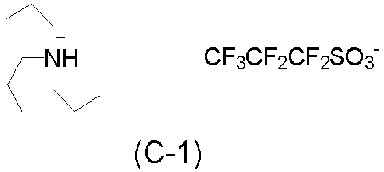

### [Compound or Polymer (D-1) Containing One or More of Epoxy, Oxetane, and Hydroxy Groups]

The compound or polymer (D-1) containing one or more of epoxy, oxetane, and hydroxy groups that was used in a composition for forming a metal-containing film is shown below.

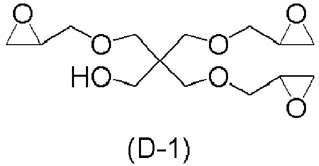

### [Crosslinking Agent (E-1)]

The crosslinking agent (E-1) used in a composition for forming a metal-containing film is shown below. As the crosslinking agent (E-1), Dipentaerythritol Hexaacrylate (manufactured by Tokyo Chemical Industry Co., Ltd.) was used.

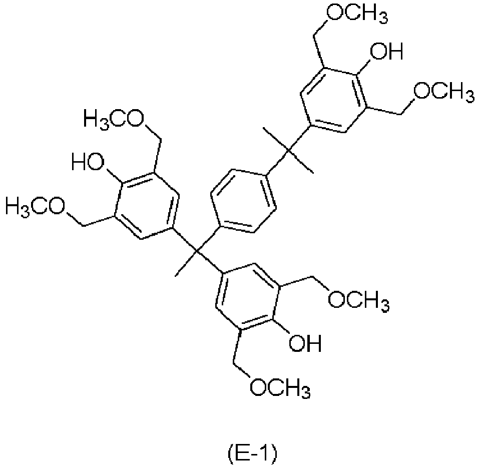

### [Synthesis Example of Polymer for Flowability Accelerator] Synthesis of Polymer (G-1) for Flowability Accelerator

Under a nitrogen atmosphere, 20.0 g of cresol novolak, 27.6 g of potassium carbonate, and 100 g of DMF were added together, and a homogeneous dispersion liquid was prepared at an internal temperature of 50°C. 11.9 g of propargyl bromide was slowly added, followed by a reaction at an internal temperature of 50°C for 24 hours. 300 ml of methylisobutylketone and 300 g of pure water were added to the reaction solution to dissolve the precipitated salts; thereafter, the separated water layer was removed. Further, the organic layer was washed with 100 g of a 3% aqueous nitric acid solution and 100 g of pure water six times, and then the organic layer was dried under reduced pressure to hardness, thereby obtaining a resin (G-1).

The weight-average molecular weight (Mw) and the dispersity (Mw/Mn) were determined by GPC, and the following results were obtained.
(G-1): Mw = 8,500, Mw/Mn = 3.46

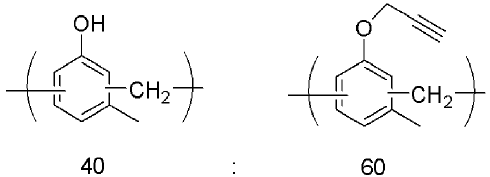

**[Table 5]**

| Composition for forming metal-containing film | Compound for forming metal-containing film (parts by mass) | Thermal acid generator (parts by mass) | Additive (parts by mass) | Solvent (including F-1) (parts by mass) (including F-1) |
|---|---|---|---|---|
| UDL-1 | A-1 (15) | C-1 (3) | - | CyHO (82) |
| UDL-2 | A-2 (15) | C-1 (3) | - | CyHO (82) |
| UDL-3 | A-3 (15) | C-1 (3) | - | CyHO (82) |
| UDL-4 | A-4 (15) | C-1 (3) | - | CyHO (82) |
| UDL-5 | A-5 (15) | C-1 (3) | - | CyHO (82) |
| UDL-6 | A-6 (15) | C-1 (3) | - | CyHO (82) |
| UDL-7 | A-7 (15) | C-1 (3) | - | CyHO (82) |
| UDL-8 | A-8 (15) | C-1 (3) | - | CyHO (82) |
| UDL-9 | A-9 (15) | C-1 (3) | - | CyHO (82) |
| UDL-10 | A-10 (15) | C-1 (3) | - | CyHO (82) |
| UDL-11 | A-11 (15) | C-1 (3) | - | CyHO (82) |
| UDL-12 | A-3 (15) | C-1 (3) | D-1 (10) | CyHO (72) |
| UDL-13 | A-5 (15) | C-1 (3) | E-1 (10) | CyHO (72) |
| UDL-14 | A-3 (15) | C-1 (3) | B1-1 (3) | CyHO (79) |
| UDL-15 | A-5 (15) | C-1 (3) | G-1 (3) | CyHO (79) |
| Comparative UDL-1 | R-1 (10) | - | - | PGMEA (90) |
| Comparative UDL-2 | R-2 (15) | - | - | PGMEA (85) |
| Comparative UDL-3 | R-3 (15) | - | - | PGMEA/CyHO (50/35) |
| Comparative UDL-4 | R-4 (15) | - | - | PGMEA/CyHO (50/35) |
| Comparative UDL-5 | R-5 (15) | - | - | PGMEA (85) |
| Comparative UDL-6 | R-6 (10) | - | - | PGMEA (90) |

PGMEA: propylene glycol monomethyl ether acetate CyHO: cyclohexanone

### [Heat Resistance Evaluation and Solvent Resistance Evaluation]

Each of the compositions (UDL-1 to -15 and comparative UDL-1 to -5) for forming a metal-containing film prepared as described above was respectively applied onto a silicon substrate and baked at 100°C for 60 seconds, and then the film thickness (a [nm]) was measured. Subsequently, after baking at the baking temperature shown in Table 6 for 60 seconds, the film thickness (b [nm]) was measured, and the difference between the film thicknesses (film remaining percentage: (b/a) × 100) before and after the additional baking was determined.

Furthermore, a PGMEA solvent was dispensed thereon, left to stand for 30 seconds, then spin-dried, and then baked at 100°C for 60 seconds to evaporate the PGMEA. The film thickness (c [nm]) was then measured.

The difference (film remaining percentage: (c/b) × 100) between the film thicknesses before and after such a PGMEA treatment was determined. The following Table 6 shows the results.

**[Table 6]**

| Example | Composition for forming metal-containing film | Baking temperature | Film thickness a | Baking temperature | Film thickness b | (b/a) × 100 | Film thickness c after PGMEA treatment | (c/b) × 100 |
|---|---|---|---|---|---|---|---|---|
| | | °C | nm | °C | nm | % | nm | % |
| Example 1-1 | UDL-1 | 100°C | 160.3 | 250°C | 70.1 | 45% | 66.9 | 95.4% |
| Example 1-2 | UDL-2 | 100°C | 164.5 | 250°C | 81.3 | 49% | 77.4 | 95.2% |
| Example 1-3 | UDL-3 | 100°C | 171.3 | 250°C | 104.5 | 61% | 104.5 | 100.0% |
| Example 1-4 | UDL-4 | 100°C | 180.1 | 250°C | 113.5 | 63% | 113.4 | 99.9% |
| Example 1-5 | UDL-5 | 100°C | 177.4 | 250°C | 113.8 | 64% | 113.8 | 100.0% |
| Example 1-6 | UDL-6 | 100°C | 188.7 | 250°C | 109.2 | 58% | 105.7 | 96.8% |
| Example 1-7 | UDL-7 | 100°C | 200.3 | 250°C | 100.2 | 50% | 97.9 | 97.7% |
| Example 1-8 | UDL-8 | 100°C | 204.4 | 250°C | 108.4 | 53% | 108.3 | 99.9% |
| Example 1-9 | UDL-9 | 100°C | 220.4 | 250°C | 110.9 | 50% | 109.8 | 99.0% |
| Example 1-10 | UDL-10 | 100°C | 199.1 | 250°C | 109.1 | 55% | 109.1 | 100.0% |
| Example 1-11 | UDL-11 | 100°C | 205.9 | 250°C | 119.7 | 58% | 119.7 | 100.0% |
| Example 1-12 | UDL-12 | 100°C | 197.9 | 250°C | 139.6 | 71% | 139.5 | 99.9% |
| Example 1-13 | UDL-13 | 100°C | 185.3 | 250°C | 121.9 | 66% | 121.4 | 99.6% |
| Example 1-14 | UDL-14 | 100°C | 172.9 | 250°C | 100.1 | 58% | 100.1 | 100.0% |
| Example 1-15 | UDL-15 | 100°C | 180.6 | 250°C | 111.9 | 62% | 111.9 | 100.0% |
| Comparative Example 1-1 | Comparative UDL-1 | 100°C | 201 | 250°C | 3.2 | 2% | - | - |
| Comparative Example 1-2 | Comparative UDL-2 | 100°C | 225.81 | 250°C | 97.1 | 43% | 96.7 | 99.6% |
| Comparative Example 1-3 | Comparative UDL-3 | 100°C | 147.06 | 250°C | 101.47 | 69% | 101.47 | 100.0% |
| Comparative Example 1-4 | Comparative UDL-4 | 100°C | 176.40 | 250°C | 2.1 | 1% | - | - |
| Comparative Example 1-5 | Comparative UDL-5 | 100°C | 314.35 | 300°C | 81.73 | 26% | 81.75 | 100.0% |

As shown in Table 6, the inventive compositions (Examples 1-1 to 1-15) for forming a metal-containing film had a film remaining percentage ((b/a) × 100) of 45% or more after the additional high-temperature baking, and it was shown that the compositions had the high-temperature baking resistance required in resist underlayer films. Particularly in Examples 1-3 to 1-15, the compositions had a film remaining percentage ((b/a) × 100) of 50% or more after the additional high-temperature baking, and exhibited better high-temperature baking resistance. It can be conjectured that this is because the compositions had sufficient molecular weight. In addition, the films using the inventive compositions (Example 1-1 to 1-15) for forming a metal-containing film and subjected to additional high-temperature baking had a film remaining percentage ((c/b) × 100) of more than 95% after the PGMEA rinsing, and it can be seen that a crosslinking reaction took place and sufficient solvent resistance was exhibited. In particular, the compositions (UDL-3, -4, -5, -8, -10, and -11) for forming a metal-containing film containing a compound having an unsaturated hydrocarbon represented by one of the general formulae (3) showed results that the compositions provided a metal-containing film that was excellent in thermosetting property and exhibited a film remaining percentage of 99.9% or more after the rinsing. Meanwhile, the films obtained using the compositions (UDL-12) and (UDL-13) for forming a metal-containing film containing the compound (D-1), having one or more of epoxy, oxetane, and hydroxy groups, or containing the crosslinking agent (E-1) resulted in improved crosslinking property and a film remaining percentage of more than 65% after the baking.

On the other hand, the film remaining percentage ((b/a) × 100) was less than 5% after the additional high-temperature baking because, in the case of comparative UDL-1, the composition did not have the structure of the general formula (1) or an unsaturated bond, and in the case of comparative UDL-4, the molecular weight was too small. Meanwhile, it was observed that comparative UDL-2 had less resistance to high-temperature baking than the inventive compounds.

In Comparative Example 1-5, the composition contained, as a compound having a different metal from the inventive compound for forming a metal-containing film, the titanium compound reported in [Synthesis Example A-II] of JP6189758B2. In this case, sufficient solvent resistance was exhibited, but the difference between the film thicknesses before and after the additional high-temperature baking was large, and it was shown that volume shrinkage due to high-temperature baking was greater than in the inventive compound for forming a metal-containing film.

### [Filling Property Evaluation]

Each of the compositions (UDL-1 to -15) for forming a metal-containing film and the comparative compositions (comparative UDL-2, -3, -5, and -6) for forming a metal-containing film was respectively applied onto an SiO₂ wafer substrate having a dense line-and-space pattern (line width = 40 nm, line depth = 120 nm, distance between the centers of two adjacent lines = 80 nm), followed by heating at the temperature shown in Table 7 for 60 seconds by using a hot plate to form a metal-containing film having a film thickness of 100 nm. The substrate used was a base substrate 9 (SiOc wafer substrate) having a dense line-and-space pattern shown in FIG. 3(Q) (downward view) and (R) (cross-sectional view). The cross-sectional shape of each of the obtained wafer substrates was observed using an electron microscope (S-4700: manufactured by Hitachi, Ltd.), and it was observed whether or not it was possible to fill a stepped substrate. Table 7 shows the results. In this evaluation, when a composition for forming a metal-containing film having a poor filling property is used, a stepped substrate cannot be filled successfully. In this evaluation, when a composition for forming a metal-containing film having a desirable filling property is used, as shown in FIG. 3(S), the space between the lines of the base substrate 9 having the dense line-and-space pattern can be filled without gaps. "Good" indicates that filling was possible without large voids, "Poor" indicates that voids were visible, and "Bad" indicates that filling was not possible.

**[Table 7]**

| Example | Composition for forming metal-containing film | Baking temperature | Filling property |
|---|---|---|---|
| | | °C | |
| Example 2-1 | UDL-1 | 250°C | Good |
| Example 2-2 | UDL-2 | 250°C | Good |
| Example 2-3 | UDL-3 | 250°C | Good |
| Example 2-4 | UDL-4 | 250°C | Good |
| Example 2-5 | UDL-5 | 250°C | Good |
| Example 2-6 | UDL-6 | 250°C | Good |
| Example 2-7 | UDL-7 | 250°C | Good |
| Example 2-8 | UDL-8 | 250°C | Good |
| Example 2-9 | UDL-9 | 250°C | Good |
| Example 2-10 | UDL-10 | 250°C | Good |
| Example 2-11 | UDL-11 | 250°C | Good |
| Example 2-12 | UDL-12 | 250°C | Good |
| Example 2-13 | UDL-13 | 250°C | Good |
| Example 2-14 | UDL-14 | 250°C | Good |
| Example 2-15 | UDL-15 | 250°C | Good |
| Comparative Example 2-1 | Comparative UDL-2 | 250°C | Good |
| Comparative Example 2-2 | Comparative UDL-3 | 250°C | Good |
| Comparative Example 2-3 | Comparative UDL-5 | 300°C | Poor |
| Comparative Example 2-4 | Comparative UDL-6 | 300°C | Good |

It was successfully confirmed that, as shown in Table 7, in Examples 2-1 to 2-15 using the inventive compositions (UDL-1 to -15) for forming a metal-containing film, it was possible to fill the dense line-and-space pattern without the generation of voids, and excellent filling property was exhibited. On the other hand, voids were observed at the bottom of the pattern in Comparative Example 2-3, using the titanium compound reported in [Synthesis Example A-II] of JP6189758B2. It is conjectured that voids were generated because volume shrinkage due to high-temperature baking was great, as observed in the solvent resistance evaluation.

### [Planarizing Property Evaluation]

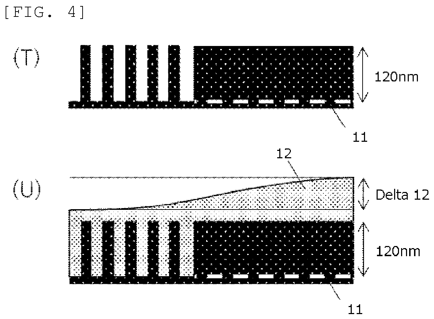

The cross sectional shape of each of the wafer substrates (substrates obtained by filling, as shown in FIG. 4(U), base substrates 11 each having a dense line-and-space pattern shown in FIG. 4(T)) obtained in the filling property evaluation was observed using a scanning electron microscope (SEM), and the step (Delta 12 in FIG. 4(U)) between the line-pattern-dense portion and the non-line-pattern portion of the filling film was observed by using an electron microscope (S-4700: manufactured by Hitachi, Ltd.). Table 8 shows the results. In the present evaluation of the wafer, it can be said that the smaller the step, the better the planarizing property.

**[Table 8]**

| Example | Composition for forming metal-containing film | Baking temperature | Flatness |
|---|---|---|---|
| | | °C | nm |
| Example 3-1 | UDL-1 | 250°C | 33 |
| Example 3-2 | UDL-2 | 250°C | 33 |
| Example 3-3 | UDL-3 | 250°C | 31 |
| Example 3-4 | UDL-4 | 250°C | 32 |
| Example 3-5 | UDL-5 | 250°C | 29 |
| Example 3-6 | UDL-6 | 250°C | 30 |
| Example 3-7 | UDL-7 | 250°C | 29 |
| Example 3-8 | UDL-8 | 250°C | 28 |
| Example 3-9 | UDL-9 | 250°C | 30 |
| Example 3-10 | UDL-10 | 250°C | 34 |
| Example 3-11 | UDL-11 | 250°C | 30 |
| Example 3-12 | UDL-12 | 250°C | 30 |
| Example 3-13 | UDL-13 | 250°C | 28 |
| Example 3-14 | UDL-14 | 250°C | 29 |
| Example 3-15 | UDL-15 | 250°C | 28 |
| Comparative Example 3-1 | Comparative UDL-2 | 250°C | 29 |
| Comparative Example 3-2 | Comparative UDL-3 | 250°C | 34 |
| Comparative Example 3-3 | Comparative UDL-5 | 300°C | 57 |
| Comparative Example 3-4 | Comparative UDL-6 | 350°C | 49 |

As shown in Table 8, it was observed that the step in the film between the patterned portion and the non-patterned portion was small and the planarization property was better in Examples 3-1 to 3-15, where the inventive compositions (UDL-1 to -15) for forming a metal-containing film were used, than in Comparative Example 3-3, where the titanium compound reported in [Synthesis Example A-II] of JP6189758B2 was used or in Comparative Example 3-4, where an organic resist underlayer film material was used. It was also observed that in the Examples, flatness was also better than in Comparative Example 3-2, where a similar tin-containing compound was used. This is considered to be because the inventive compounds contribute to the improvement of thermal flowability by having a thermal acid leaving group.

Meanwhile, in Examples 3-14 and 3-15, where a high-boiling-point solvent (B1-1) or a flowability accelerator (G-1) was contained, better planarizing property was exhibited than in Example 3-3 and Example 3-5, where neither additive was contained. It can be observed that the thermal flowability of a compound for forming a metal-containing film can be improved further by using a high-boiling-point solvent (B1-1) and/or a flowability accelerator (G-1).

### [Etching Resistance Evaluation]

Each of the compositions (UDL-1 to -15) for forming a metal-containing film and the comparative compositions (comparative UDL-2, -3, -5, and -6) for forming a metal-containing film was respectively applied onto a silicon substrate and heated by using a hot plate at the temperature shown in Table 9 for 60 seconds to form a metal-containing film having a film thickness of 100 nm, and the film thickness A was measured. Subsequently, etching was performed with CF₄ gas, O₂ gas, and Cl₂ gas under the following conditions for the specified number of seconds by using an etching apparatus CE-300I manufactured by ULVAC, Inc., and then the film thickness B was measured. Then, the film thickness etched in the respective number of seconds ("film thickness B" - "film thickness A") was calculated. Table 9 shows the results.

Conditions of dry etching with CF₄ gas
Pressure: 1 Pa
Antenna RF power: 100 W
Bias RF power: 15 W
CF₄ gas flow rate: 15 sccm
Time: 30 sec

Conditions of dry etching with O₂ gas
Pressure: 1 Pa
Antenna RF power: 300 W
Bias RF power: 0 W
O₂ gas flow rate: 25 sccm
Time: 20 sec

Conditions of dry etching with Cl₂ gas
Pressure: 1 Pa
Antenna RF power: 320 W
Bias RF power: 30 W
Cl₂ gas flow rate: 25 sccm
Time: 10 sec

**[Table 9]**

| Example | Composition for forming metal-containing film | Baking temperature | Etching resistance | | |
|---|---|---|---|---|---|
| | | °C | CF | O₂ | Cl₂ |
| Example 4-1 | UDL-1 | 250°C | 31 | 5 | 520 |
| Example 4-2 | UDL-2 | 250°C | 29 | 5 | 510 |
| Example 4-3 | UDL-3 | 250°C | 28 | 6 | 500 |
| Example 4-4 | UDL-4 | 250°C | 28 | 5 | 520 |
| Example 4-5 | UDL-5 | 250°C | 28 | 5 | 530 |
| Example 4-6 | UDL-6 | 250°C | 29 | 8 | 510 |
| Example 4-7 | UDL-7 | 250°C | 27 | 9 | 510 |
| Example 4-8 | UDL-8 | 250°C | 27 | 9 | 500 |
| Example 4-9 | UDL-9 | 250°C | 29 | 12 | 490 |
| Example 4-10 | UDL-10 | 250°C | 27 | 8 | 510 |
| Example 4-11 | UDL-11 | 250°C | 30 | 9 | 500 |
| Example 4-12 | UDL-12 | 250°C | 35 | 15 | 450 |
| Example 4-13 | UDL-13 | 250°C | 36 | 21 | 440 |
| Example 4-14 | UDL-14 | 250°C | 27 | 7 | 520 |
| Example 4-15 | UDL-15 | 250°C | 30 | 7 | 530 |
| Comparative Example 4-1 | Comparative UDL-2 | 250°C | 29 | 8 | 520 |
| Comparative Example 4-2 | Comparative UDL-3 | 250°C | 29 | 7 | 520 |
| Comparative Example 4-3 | Comparative UDL-5 | 300°C | 30 | 10 | 105 |
| Comparative Example 4-4 | Comparative UDL-6 | 350°C | 65 | 210 | 130 |

As shown in Table 9, it was shown that better CF₄ etching resistance and O₂ etching resistance were exhibited in Examples 4-1 to 4-15, where the compositions (UDL-1 to -15) for forming a resist metal-containing film of the present invention were used, Comparative Example 4-1 and Comparative Example 4-2, where similar compositions (comparative UDL-2 and comparative UDL-3) for forming a metal-containing film were used, and Comparative Example 4-3, where a titanium compound was used, than in Comparative Example 4-4, where comparative UDL-6, being an organic resist underlayer film material, was used. In addition, it was revealed that, while the compositions in Examples 4-1 to 4-15 and Comparative Examples 4-1 and 4-2, which were tin-containing compositions, exhibited excellent resistance to etching with CF₄ gas and O₂ gas, the compositions exhibited excellent removability by etching with Cl₂ gas.

### [Patterning Test (Examples 5-1 to 5-15 and Comparative Examples 5-1 and 5-2)]

Each of the compositions (UDL-1 to -15) for forming a metal-containing film and the comparative compositions (comparative UDL-5 and -6) for forming a metal-containing film was respectively applied onto an SiO₂ wafer substrate having a trench pattern (trench width: 10 um, trench depth: 0.10 µm), and baked at 250°C for 60 seconds in the atmosphere to form a metal-containing film having a thickness of 100 nm. A silicon-containing resist middle layer material (SOG-1) was applied thereto, followed by baking at 220°C for 60 seconds to form a resist middle layer film having a thickness of 30 nm. A monolayer resist for ArF as a resist upper layer film material was applied thereto, followed by baking at 105°C for 60 seconds to form a photoresist film having a thickness of 100 nm. A liquid immersion top coat composition (TC-1) was applied to the photoresist film, followed by baking at 90°C for 60 seconds to form a top coat having a thickness of 50 nm.

The silicon-containing resist middle layer material (SOG-1) was prepared by dissolving a polymer represented by an ArF silicon-containing middle layer film polymer (SiP1) and a crosslinking catalyst (CAT1) in an organic solvent (propylene glycol monoethyl ether (PGEE)) containing 0.1 mass% of FC-4430 (manufactured by Sumitomo 3M Limited) in the proportion shown in Table 10; and filtering the solution through a filter made of a fluororesin and having a pore size of 0.1 um.

The structural formulae of the of the ArF silicon-containing middle layer film polymer (SiP1) and the thermal crosslinking catalyst (CAT1) used are shown below.

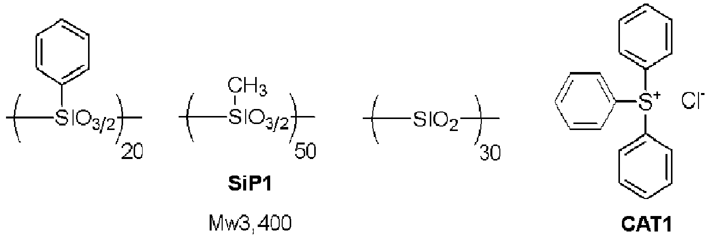

**[Table 10]**

| | Polymer | Thermal crosslinking catalyst | Organic solvent |
|---|---|---|---|
| | (parts by mass) | (parts by mass) | (parts by mass) |
| SOG-1 | SiP1 (100) | CAT1 (1) | PGEE (4000) |

The resist upper layer film material (monolayer resist for ArF) was prepared by dissolving a polymer (RP1), an acid generator (PAG1), and a basic compound (Amine1), each in the proportion shown in Table 11, in a solvent (propylene glycol monomethyl ether acetate (PGMEA)) containing 0.1% by mass of a surfactant (FC-4430: manufactured by Sumitomo 3M Limited), and filtering the solution through a 0.1-µm filter made of a fluororesin.

**[Table 11]**

| | Polymer | Acid generator | Basic compound | Solvent |
|---|---|---|---|---|
| | (parts by mass) | (parts by mass) | (parts by mass) | (parts by mass) |
| Monolayer resist for ArF | RP1 (100) | PAG1 (6.6) | Amine1 (0.8) | PGMEA (2500) |

The polymer (RP1), the acid generator (PAG1), and the basic compound (Amine1) used for the resist upper layer film material (monolayer resist for ArF) are shown below.

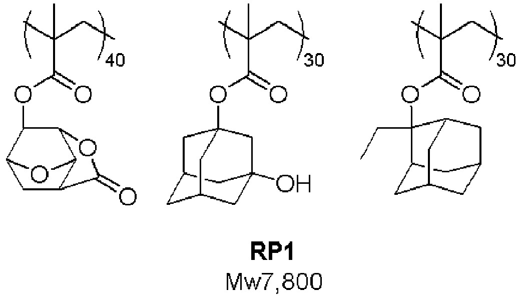

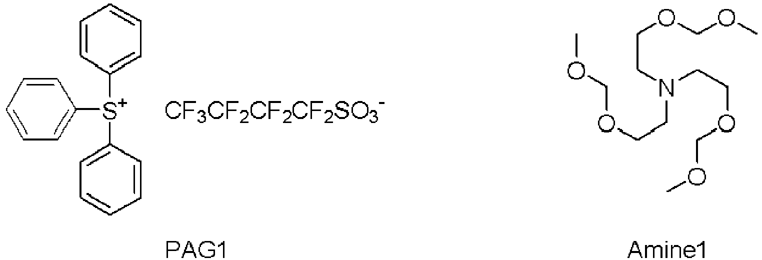

The liquid immersion top coat composition (TC-1) was prepared by dissolving a top coat polymer (PP1) in an organic solvent at the proportion shown in Table 12, and filtering the solution through a 0.1-pm filter made of a fluororesin.

**[Table 12]**

| | Polymer | Organic solvent |
|---|---|---|
| | (parts by mass) | (parts by mass) |
| TC-1 | PP1 (100) | Diisoamyl ether (2700) 2-methyl-1-butanol (270) |

The polymer (PP1) used for the liquid immersion top coat composition (TC-1) is shown below.

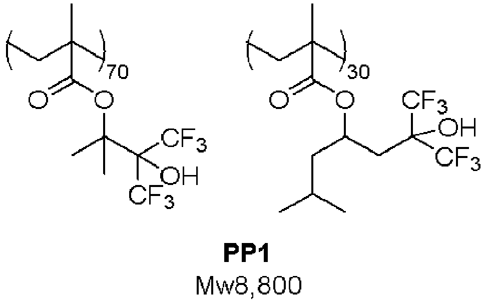

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 55 nm 1:1 positive line-and-space pattern (a resist pattern).

Subsequently, the silicon-containing resist middle layer material (SOG-1) was etched by dry etching while using the resist pattern as a mask to form a hard mask pattern. The metal-containingoxide film was then etched while using the obtained hard mask pattern as a mask to form a metal-containing film pattern, and the SiO₂ film was etched while using the obtained metal-containing film pattern as a mask. The etching conditions were as follows.

Conditions in transferring resist pattern to silicon-containing resist middle layer material (SOG-1)
Conditions of dry etching with CF₄ gas
Pressure: 1 Pa
Antenna RF power: 100 W
Bias RF power: 15 W
CF₄ gas flow rate: 15 sccm
Time: 60 sec

Conditions in transferring SOG-1 hard mask pattern to metal-containing film
Pressure: 1 Pa
Antenna RF power: 320 W
Bias RF power: 30 W
Cl₂ gas flow rate: 25 sccm
Time (Example 5-1 to Example 5-13): 15 sec
Time (Comparative Example 5-1 and Comparative Example 5-2): 60 sec

Conditions in transferring metal-containing film pattern to SiO₂ film
Conditions of dry etching with CF₄ gas
Pressure: 1 Pa
Antenna RF power: 100 W
Bias RF power: 15 W
CF₄ gas flow rate: 15 sccm
Time: 60 sec

Table 13 shows the results obtained by observation of the pattern cross section with an electron microscope (S-4700) manufactured by Hitachi, Ltd.

**[Table 13]**

| Example | Composition for forming metal-containing film | Pattern profile after etching for transferring to substrate |
|---|---|---|
| Example 5-1 | UDL-1 | Vertical profile |
| Example 5-2 | UDL-2 | Vertical profile |
| Example 5-3 | UDL-3 | Vertical profile |
| Example 5-4 | UDL-4 | Vertical profile |
| Example 5-5 | UDL-5 | Vertical profile |
| Example 5-6 | UDL-6 | Vertical profile |
| Example 5-7 | UDL-7 | Vertical profile |
| Example 5-8 | UDL-8 | Vertical profile |
| Example 5-9 | UDL-9 | Vertical profile |
| Example 5-10 | UDL-10 | Vertical profile |
| Example 5-11 | UDL-11 | Vertical profile |
| Example 5-12 | UDL-12 | Vertical profile |
| Example 5-13 | UDL-13 | Vertical profile |
| Example 5-14 | UDL-14 | Vertical profile |
| Example 5-15 | UDL-15 | Vertical profile |
| Comparative Example 5-1 | Comparative UDL-5 | Pattern collapse |
| Comparative Example 5-2 | Comparative UDL-6 | Distorted pattern |

As shown in Table 13, in Examples 5-1 to 5-15, where the compositions (UDL-1 to -15) of the present invention for forming a metal-containing film were used, the resist upper layer film pattern was successfully transferred to the substrate in the end in every case. Thus, it was confirmed that the composition of the present invention for forming a metal-containing film can be used suitably for fine processing using a multilayer resist method. On the other hand, in Comparative Example 5-1, where the performance in the filling property evaluation and the planarizing property evaluation was found to be insufficient, pattern collapse occurred during patterning, and it was not possible to obtain a favorable pattern in the end. Meanwhile, in Comparative Example 5-2, where there were no problems in the filling property and planarizing property evaluation but insufficient performance was observed in the dry etching resistance evaluation, distortion of the pattern profile occurred at the time of pattern processing, and it was not possible to obtain a favorable pattern in the end.

From the above, the compound of the present invention for forming a metal-containing film is an organotin compound having both high thermal flowability and high thermosetting property, so that a composition for forming a metal-containing film containing the compound can provide a composition for forming a metal-containing film having better dry etching resistance than conventional organic underlayer film materials and also having high filling and planarizing properties. Therefore, such a composition is extremely useful as, for example, a resist underlayer film material used in a multilayer resist method and an inverting agent used in a tone-reversal etching method.

The present invention includes the following embodiments.
[1] A compound for forming a metal-containing film, wherein the compound is represented by the following general formula (M),

   Tₙ-Sn-Qₘ, (M)

   wherein "m" and "n" represent integers that satisfy relationships m + n = 4, m ≥ 1, and n ≥ 2; T's each represent a unit represented by the following general formula (1), the T's being identical to or different from each other and optionally being a combination of a plurality of units; and Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups, 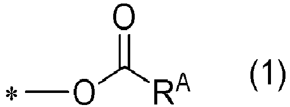 wherein R^{A} represents an organic group whose protecting group is to be removed by an action of an acid, heat, or both to generate one or more hydroxy groups or carboxyl groups, R^{A} being a group represented by one of the following general formulae (R^{A}-1) to (R^{A}-4); and "*" represents an attachment point to a Sn atom, 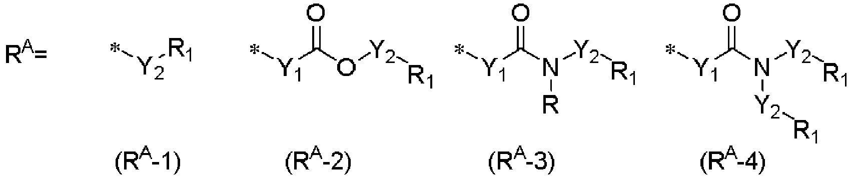 wherein Y₁ and Y₂ are identical to or different from each other and each represent a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms; R represents a hydrogen atom, a substituted or unsubstituted saturated monovalent organic group having 1 to 20 carbon atoms, a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms; R₁ represents an organic group represented by one of the following general formulae (2), wherein a protecting group of the organic group is to be removed by an action of an acid, heat, or both to generate one or more hydroxy groups or carboxyl groups; and "*" represents an attachment point to a carbonyl group, 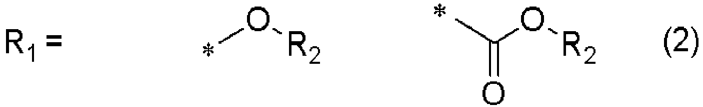 wherein R₂ represents an organic group whose protecting group is to be removed by an action of an acid, heat, or both and represents a tertiary hydrocarbyl group or a group that forms an acetal structure together with an adjacent oxygen atom; and "*" represents an attachment point to Y₂.
[2] The compound for forming a metal-containing film according to [1], wherein the Y₁ in the general formulae (R^{A}-1) to (R^{A}-4) represents an unsaturated hydrocarbon group having 2 to 20 carbon atoms.
[3] The compound for forming a metal-containing film according to [1] or [2], wherein the Y₁ in the general formulae (R^{A}-1) to (R^{A}-4) represents one of the following general formulae (3), 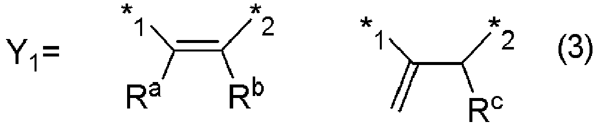 wherein R^{a}, R^{b}, and R^{c} each represent a hydrogen atom or a monovalent organic group having 1 to 20 carbon atoms, R^{a} and R^{b} optionally being bonded to each other to form a cyclic substituent; and "*1" and "*2" each represent an attachment point to a carbonyl group, "*1" and "*2" optionally being reversed.
[4] The compound for forming a metal-containing film according to any one of [1] to [3], wherein the compound for forming a metal-containing film satisfies 1.00 ≤ Mw/Mn ≤ 1.50, where Mw is a weight-average molecular weight and Mn is a number-average molecular weight measured by gel permeation chromatography in terms of polystyrene.
[5] A composition for forming a metal-containing film, comprising:
   (A) the compound for forming a metal-containing film according to any one of [1] to [4];
   (B) an organic solvent; and
   (C) an acid generator.
[6] The composition for forming a metal-containing film according to [5], further comprising one or more of:
   (D) a compound or a polymer containing one or more of epoxy, oxetane, and hydroxy groups;
   (E) a crosslinking agent;
   (F) a surfactant; and
   (G) a flowability accelerator.
[7] The composition for forming a metal-containing film according to [5] or [6], wherein the organic solvent (B) contains (B1) a high-boiling-point solvent, the high-boiling-point solvent (B1) being one or more kinds of organic solvent having a boiling point of 180°C or higher.
[8] A patterning process for forming a pattern in a substrate to be processed, comprising the steps of:
   (I-1) applying the composition for forming a metal-containing film according to any one of [5] to [7] onto a substrate to be processed, followed by heating to form a metal-containing film;
   (I-2) forming a resist upper layer film on the metal-containing film by using a photoresist material;
   (I-3) subjecting the resist upper layer film to pattern exposure and then development with a developer to form a pattern in the resist upper layer film;
   (I-4) transferring the pattern to the metal-containing film by dry etching while using the resist upper layer film having the formed pattern as a mask; and
   (I-5) processing the substrate to be processed while using the metal-containing film having the formed pattern as a mask to form the pattern in the substrate to be processed.
[9] A patterning process for forming a pattern in a substrate to be processed, comprising the steps of:
   (II-1) applying the composition for forming a metal-containing film according to any one of [5] to [7] onto a substrate to be processed, followed by heating to form a metal-containing film;
   (II-2) forming a silicon-containing resist middle layer film on the metal-containing film;
   (II-3) forming a resist upper layer film on the silicon-containing resist middle layer film by using a photoresist material;
   (II-4) subjecting the resist upper layer film to pattern exposure and then development with a developer to form a pattern in the resist upper layer film;
   (II-5) transferring the pattern to the silicon-containing resist middle layer film by dry etching while using the resist upper layer film having the formed pattern as a mask;
   (II-6) transferring the pattern to the metal-containing film by dry etching while using the silicon-containing resist middle layer film having the transferred pattern as a mask; and
   (II-7) processing the substrate to be processed while using the metal-containing film having the formed pattern as a mask to form the pattern in the substrate to be processed.
[10] A patterning process for forming a pattern in a substrate to be processed, comprising the steps of:
   (III-1) applying the composition for forming a metal-containing film according to any one of [5] to [7] onto a substrate to be processed, followed by heating to form a metal-containing film;
   (III-2) forming an inorganic hard mask middle layer film selected from the group consisting of a silicon oxide film, a silicon nitride film, and a silicon oxynitride film on the metal-containing film;
   (III-3) forming an organic thin film on the inorganic hard mask middle layer film;
   (III-4) forming a resist upper layer film on the organic thin film by using a photoresist material;
   (III-5) subjecting the resist upper layer film to pattern exposure and then development with a developer to form a pattern in the resist upper layer film;
   (III-6) transferring the pattern to the organic thin film and the inorganic hard mask middle layer film by dry etching while using the resist upper layer film having the formed pattern as a mask;
   (III-7) transferring the pattern to the metal-containing film by dry etching while using the inorganic hard mask middle layer film having the transferred pattern as a mask; and
   (III-8) processing the substrate to be processed while using the metal-containing film having the formed pattern as a mask to form the pattern in the substrate to be processed.
[11] The patterning process according to [10], wherein the inorganic hard mask middle layer film is formed by a CVD method or an ALD method.
[12] A patterning process for forming a pattern in a substrate to be processed, comprising the steps of:
   (IV-1) forming a resist underlayer film on a substrate to be processed;
   (IV-2) applying the composition for forming a metal-containing film according to any one of [5] to [7] onto the resist underlayer film, followed by heating to form a metal-containing film;
   (IV-3) forming a resist upper layer film on the metal-containing film by using a photoresist material or forming an organic adhesive film on the metal-containing film by spin-coating and forming a resist upper layer film on the organic adhesive film by using a photoresist material;
   (IV-4) subjecting the resist upper layer film to pattern exposure and then development with a developer to form a pattern in the resist upper layer film;
   (IV-5) transferring the pattern to the organic adhesive film and the metal-containing film or the metal-containing film by dry etching while using the resist upper layer film having the formed pattern as a mask;
   (IV-6) transferring the pattern to the resist underlayer film by dry etching while using the metal-containing film having the transferred pattern as a mask; and
   (IV-7) processing the substrate to be processed while using the resist underlayer film having the formed pattern as a mask to form the pattern in the substrate to be processed.
[13] A tone-reversal patterning process for forming a pattern in a substrate to be processed, comprising the steps of:
   (V-1) forming a resist underlayer film on a substrate to be processed;
   (V-2) forming a resist middle layer film or a combination of an organic thin film and an inorganic hard mask middle layer film selected from the group consisting of a silicon oxide film, a silicon nitride film, and a silicon oxynitride film on the resist underlayer film;
   (V-3) forming a resist upper layer film on the resist middle layer film or the combination of the organic thin film and the inorganic hard mask middle layer film by using a photoresist material;
   (V-4) subjecting the resist upper layer film to pattern exposure and then development with a developer to form a pattern in the resist upper layer film;
   (V-5) transferring the pattern to the resist middle layer film or the organic thin film and the inorganic hard mask middle layer film by dry etching while using the resist upper layer film having the formed pattern as a mask;
   (V-6) transferring the pattern to the resist underlayer film by dry etching while using the resist middle layer film having the transferred pattern or the inorganic hard mask middle layer film having the transferred pattern as a mask;
   (V-7) applying the composition for forming a metal-containing film according to any one of [5] to [7] onto the resist underlayer film having the formed pattern, followed by heating to cover the resist underlayer film with a metal-containing film, thereby filling a space between the resist underlayer film patterns with the metal-containing film;
   (V-8) etching back the metal-containing film covering the resist underlayer film having the formed pattern by a chemical stripper or dry etching to expose an upper surface of the resist underlayer film having the formed pattern;
   (V-9) removing the resist middle layer film or the inorganic hard mask middle layer film remaining on the upper surface of the resist underlayer film by dry etching;
   (V-10) removing the resist underlayer film having the formed pattern with its surface exposed by dry etching to form a reverse pattern of an original pattern on the metal-containing film; and
   (V-11) processing the substrate to be processed while using the metal-containing film having the formed reverse pattern as a mask to form the reverse pattern in the substrate to be processed.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A compound for forming a metal-containing film, wherein the compound is represented by the following general formula (M),
Tₙ-Sn-Qₘ (M)
wherein "m" and "n" represent integers that satisfy relationships m + n = 4, m ≥ 1, and n ≥ 2; T's each represent a unit represented by the following general formula (1), the T's being identical to or different from each other and optionally being a combination of a plurality of units; and Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups, 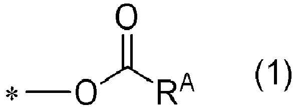 wherein R^{A} represents an organic group whose protecting group is to be removed by an action of an acid, heat, or both to generate one or more hydroxy groups or carboxyl groups, R^{A} being a group represented by one of the following general formulae (R^{A}-1) to (R^{A}-4); and "*" represents an attachment point to a Sn atom, 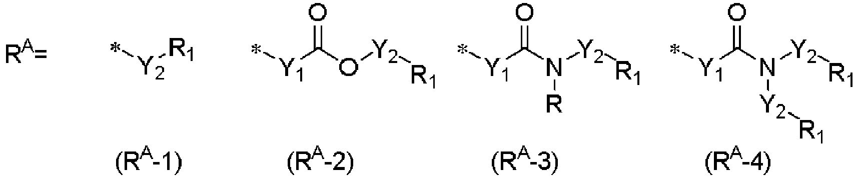 wherein Y₁ and Y₂ are identical to or different from each other and each represent a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms; R represents a hydrogen atom, a substituted or unsubstituted saturated monovalent organic group having 1 to 20 carbon atoms, a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms; R₁ represents an organic group represented by one of the following general formulae (2), wherein a protecting group of the organic group is to be removed by an action of an acid, heat, or both to generate one or more hydroxy groups or carboxyl groups; and "*" represents an attachment point to a carbonyl group, 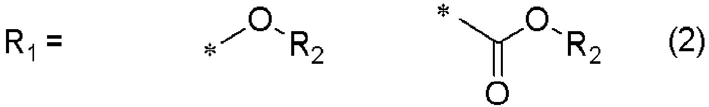 wherein R₂ represents an organic group whose protecting group is to be removed by an action of an acid, heat, or both and represents a tertiary hydrocarbyl group or a group that forms an acetal structure together with an adjacent oxygen atom; and "*" represents an attachment point to Y₂.

2. The compound for forming a metal-containing film according to claim 1, wherein the Y₁ in the general formulae (R^{A}-1) to (R^{A}-4) represents an unsaturated hydrocarbon group having 2 to 20 carbon atoms.

3. The compound for forming a metal-containing film according to claim 1 or 2, wherein the Y₁ in the general formulae (R^{A}-1) to (R^{A}-4) represents one of the following general formulae (3), 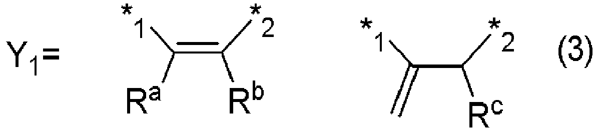 wherein R^{a}, R^{b}, and R^{c} each represent a hydrogen atom or a monovalent organic group having 1 to 20 carbon atoms, R^{a} and R^{b} optionally being bonded to each other to form a cyclic substituent; and "*1" and "*2" each represent an attachment point to a carbonyl group, "*1" and "*2" optionally being reversed.

4. The compound for forming a metal-containing film according to any one of claims 1 to 3, wherein the compound for forming a metal-containing film satisfies 1.00 ≤ Mw/Mn ≤ 1.50, where Mw is a weight-average molecular weight and Mn is a number-average molecular weight measured by gel permeation chromatography in terms of polystyrene.

5. A composition for forming a metal-containing film, comprising:
(A) the compound for forming a metal-containing film according to any one of claims 1 to 4;
(B) an organic solvent; and
(C) an acid generator.

6. The composition for forming a metal-containing film according to claim 5, further comprising one or more of:
(D) a compound or a polymer containing one or more of epoxy, oxetane, and hydroxy groups;
(E) a crosslinking agent;
(F) a surfactant; and
(G) a flowability accelerator.

7. The composition for forming a metal-containing film according to claim 5 or 6, wherein the organic solvent (B) contains (B1) a high-boiling-point solvent, the high-boiling-point solvent (B1) being one or more kinds of organic solvent having a boiling point of 180°C or higher.

8. A patterning process for forming a pattern in a substrate to be processed, comprising the steps of:
(I-1) applying the composition for forming a metal-containing film according to any one of claims claim 5 to 7 onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

9. A patterning process for forming a pattern in a substrate to be processed, comprising the steps of:
(II-1) applying the composition for forming a metal-containing film according to any one of claims claim 5 to 7 onto a substrate to be processed, followed by heating to form a metal-containing film;
(II-2) forming a silicon-containing resist middle layer film on the metal-containing film;
(II-3) forming a resist upper layer film on the silicon-containing resist middle layer film by using a photoresist material;
(II-4) subjecting the resist upper layer film to pattern exposure and then development with a developer to form a pattern in the resist upper layer film;
(II-5) transferring the pattern to the silicon-containing resist middle layer film by dry etching while using the resist upper layer film having the formed pattern as a mask;
(II-6) transferring the pattern to the metal-containing film by dry etching while using the silicon-containing resist middle layer film having the transferred pattern as a mask; and
(II-7) processing the substrate to be processed while using the metal-containing film having the formed pattern as a mask to form the pattern in the substrate to be processed.

10. A patterning process for forming a pattern in a substrate to be processed, comprising the steps of:
(III-1) applying the composition for forming a metal-containing film according to any one of claims claim 5 to 7 onto a substrate to be processed, followed by heating to form a metal-containing film;
(III-2) forming an inorganic hard mask middle layer film selected from the group consisting of a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

11. The patterning process according to claim 10, wherein the inorganic hard mask middle layer film is formed by a CVD method or an ALD method.

12. A patterning process for forming a pattern in a substrate to be processed, comprising the steps of:
(IV-1) forming a resist underlayer film on a substrate to be processed;
(IV-2) applying the composition for forming a metal-containing film according to any one of claims claim 5 to 7 onto the resist underlayer film, followed by heating to form a metal-containing film;
(IV-3) forming a resist upper layer film on the metal-containing film by using a photoresist material or forming an organic adhesive film on the metal-containing film by spin-coating and forming a resist upper layer film on the organic adhesive film by using a photoresist material;
(IV-4) subjecting the resist upper layer film to pattern exposure and then development with a developer to form a pattern in the resist upper layer film;
(IV-5) transferring the pattern to the organic adhesive film and the metal-containing film or the metal-containing film by dry etching while using the resist upper layer film having the formed pattern as a mask;
(IV-6) transferring the pattern to the resist underlayer film by dry etching while using the metal-containing film having the transferred pattern as a mask; and
(IV-7) processing the substrate to be processed while using the resist underlayer film having the formed pattern as a mask to form the pattern in the substrate to be processed.

13. A tone-reversal patterning process for forming a pattern in a substrate to be processed, comprising the steps of:
(V-1) forming a resist underlayer film on a substrate to be processed;
(V-2) forming a resist middle layer film or a combination of an organic thin film of an inorganic hard mask middle layer film selected from the group consisting of a silicon oxide film, a silicon nitride film, and a silicon oxynitride film on the resist underlayer film;
(V-3) forming a resist upper layer film on the resist middle layer film or the combination of the organic thin film and the inorganic hard mask middle layer film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film having the transferred pattern or the inorganic hard mask middle layer film having the transferred pattern as a mask;
(V-7) applying the composition for forming a metal-containing film according to any one of claims claim 5 to 7 onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing the resist underlayer film having the formed pattern with its surface exposed by dry etching to form a reverse pattern of an original pattern on the metal-containing film; and
(V-11) processing the substrate to be processed while using the metal-containing film having the formed reverse pattern as a mask to form the reverse pattern in the substrate to be processed.
